# EUROPEAN PATENT APPLICATION

(11) **EP 4 841 347 A1**
(43) Date of publication of application: **18.11.2026**
(21) Application number: 25738846.2
(22) Date of filing: 10.01.2025
(51) Int. Cl.: G03F 7/11

(54) **COMPOSITION FOR FORMING RESIST UNDERLAYER FILM**

(30) Priority: 11.01.2024 JP 2024002547
(71) Applicant: Nissan Chemical Corporation, Tokyo 103-6119 (JP)
(72) Inventor: ITAOKA, Kohei, Toyama-shi, Toyama 939-2792 (JP); OGATA, Hiroto, Toyama-shi, Toyama 939-2792 (JP); TAMURA, Mamoru, Toyama-shi, Toyama 939-2792 (JP)
(74) Representative: Hoffmann Eitle
(86) International application number: PCT/JP2025/000593
(87) International publication number: WO 2025/150548

(57) **Abstract**

A resist underlayer film-forming composition including: a polymer (A) containing a phenolic hydroxy group and a nitro group; and a solvent (B).

## Description

### Technical Field

The present invention relates to a resist underlayer film-forming composition, a resist underlayer film, a laminate, a method for producing a semiconductor element, and a pattern forming method.

### Background Art

Conventionally, microfabrication by lithography using a resist composition has been performed in the production of a semiconductor device. The microfabrication is a processing method of forming microrelief corresponding to a photoresist pattern on a substrate surface by forming a thin film of a photoresist composition on a semiconductor substrate such as a silicon wafer, irradiating the thin film with an active ray such as an ultraviolet ray through a mask pattern on which a device pattern is drawn, developing the thin film, and etching the substrate using the obtained photoresist pattern as a protective film. In recent years, the degree of integration of a semiconductor device has been increased, and as an active ray to be used, EUV light (wavelength: 13.5 nm) or an electron beam (EB) has been studied to be put into practical use for the most advanced microfabrication, in addition to an i-line (wavelength: 365 nm), a KrF excimer laser (wavelength: 248 nm), and an ArF excimer laser (wavelength: 193 nm) which have conventionally been used. At the same time, defects in the formation of the resist pattern due to an influence of the semiconductor substrate and the like are a big problem. Therefore, in order to solve this problem, a method of providing a resist underlayer film between a resist and a semiconductor substrate has been widely studied.

As a composition for forming a resist underlayer film, a composition for forming a resist underlayer film which contains a polymer or a compound having a structure represented by formula (100) (in the formula (100), Ar represents an optionally substituted aromatic ring group having 6 to 40 carbon atoms; L⁰ represents a single bond, an ester bond, an ether bond, an optionally substituted alkylene group having 1 to 10 carbon atoms, or an optionally substituted alkenylene group having 2 to 10 carbon atoms; and T⁰ represents a single bond, an ester bond, an ether bond, an optionally substituted alkylene group having 1 to 10 carbon atoms, or an optionally substituted alkenylene group having 2 to 10 carbon atoms, wherein, L⁰ and T⁰ are different from each other; n R⁰'s independently represent a hydroxy group, a halogen atom, a nitro group, a cyano group, an amino group, or a monovalent organic group; n represents an integer from 0 to 5; and * represents a linking moiety with a polymer or compound residue) and a solvent has been proposed (see Patent Literature 1).

### Citation List

### Patent Literature

Patent Literature 1: WO 2022/196662 A

### Summary of Invention

### Technical Problem

Examples of the characteristics required for a resist underlayer film include that no intermixing with a resist film formed on an upper layer occurs (the resist underlayer film is insoluble in a resist solvent), and that a resist pattern having good quality can be formed by improving sensitivity and adhesion of a resist pattern.

The present invention has been made in view of the above circumstances, and an object of the present invention is to provide a resist underlayer film-forming composition capable of forming a resist pattern having good quality by improving sensitivity and adhesion, and a resist underlayer film, a laminate, a method for producing a semiconductor element, and a pattern forming method, each using the resist underlayer film-forming composition.

### Solution to Problem

As a result of intensive studies to solve the above problem, the present inventors have found that the above problem can be solved and have completed the present invention having the following gist.

That is, the present invention includes the following aspects.
[1] A resist underlayer film-forming composition including:
   a polymer (A) containing a phenolic hydroxy group and a nitro group; and
   a solvent (B).
[2] The resist underlayer film-forming composition according to [1], wherein the polymer (A) is a vinyl polymer.
[3] The resist underlayer film-forming composition according to [1] or [2], wherein the polymer (A) contains a structural unit (A1) represented by formula (A1) below and a structural unit (A2) represented by formula (A2) below: 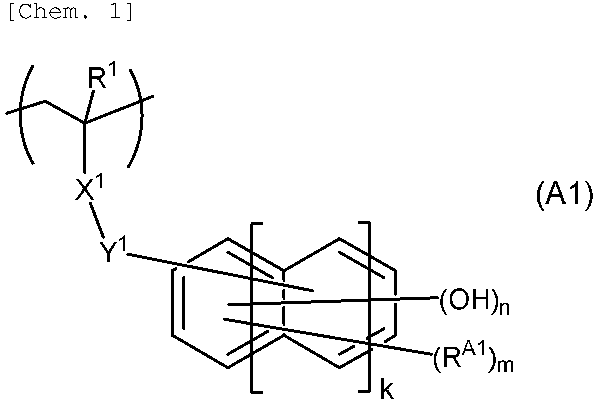 in the formula (A1), R¹ represents a hydrogen atom or a methyl group, X¹ represents a single bond, an ester bond or an amide bond, Y¹ represents a single bond or an alkylene group having 1 to 4 carbon atoms, R^{A1} represents a halogen atom, a carboxy group, a cyano group, a methylenedioxy group, an acetoxy group, a methylthio group, an amino group, an alkyl group having 1 to 9 carbon atoms or an alkoxy group having 1 to 9 carbon atoms, n represents an integer from 1 to 7, m represents an integer from 0 to 6, k represents an integer from 0 to 2, and when m is 2 or more, m R^{A1}'s may be the same or different; 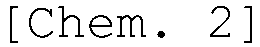 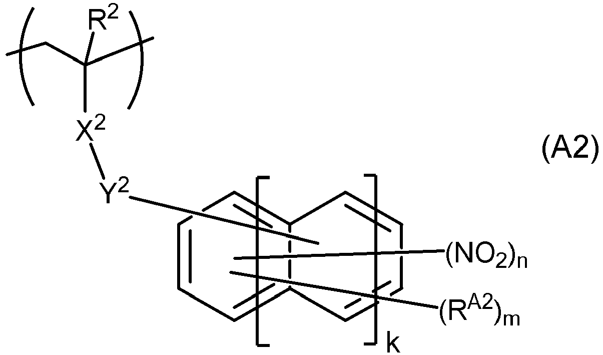 in the formula (A2), R² represents a hydrogen atom or a methyl group, X² represents a single bond, an ester bond or an amide bond, Y² represents a single bond or an alkylene group having 1 to 4 carbon atoms, R^{A2} represents a halogen atom, a carboxy group, a cyano group, a methylenedioxy group, an acetoxy group, a methylthio group, an amino group, an alkyl group having 1 to 9 carbon atoms or an alkoxy group having 1 to 9 carbon atoms, n represents an integer from 1 to 7, m represents an integer from 0 to 6, k represents an integer from 0 to 2, and when m is 2 or more, m R^{A2}'s may be the same or different.
[4] The resist underlayer film-forming composition according to any one of [1] to [3], wherein the solvent (B) contains at least one type selected from a group consisting of an alkylene glycol monoalkyl ether and a monocarboxylic acid ester of an alkylene glycol monoalkyl ether.
[5] The resist underlayer film-forming composition according to any one of [1] to [4], further containing a crosslinking agent (C).
[6] The resist underlayer film-forming composition according to [5], wherein the crosslinking agent (C) is at least one selected from the group consisting of aminoplast crosslinking agents and phenoplast crosslinking agents.
[7] The resist underlayer film-forming composition according to any one of [1] to [6], further including a curing catalyst (D).
[8] The resist underlayer film-forming composition according to any one of [1] to [7], which is used in EUV lithography.
[9] The resist underlayer film-forming composition according to any one of [1] to [8], wherein the composition is used for forming an underlayer film of a metal-containing resist.
[10] A resist underlayer film which is a cured product of the resist underlayer film-forming composition according to any one of [1] to [9].
[11] A laminate, including:
   a semiconductor substrate; and
   the resist underlayer film according to [10].
[12] A method for producing a semiconductor element, including:
   a step of forming a resist underlayer film on a semiconductor substrate using the resist underlayer film-forming composition according to any one of [1] to [9]; and
   a step of forming a resist film on the resist underlayer film.
[13] A pattern forming method, including:
   a step of forming a resist underlayer film on a semiconductor substrate using the resist underlayer film-forming composition according to any one of [1] to [9];
   a step of forming a resist film on the resist underlayer film;
   a step of irradiating the resist film with light or an electron beam, and then developing the resist film to obtain a resist pattern; and
   a step of etching the resist underlayer film using the resist pattern as a mask.

### Advantageous Effects of Invention

According to the present invention, it is possible to provide a resist underlayer film-forming composition capable of forming a resist pattern having good quality by improving sensitivity and adhesion, and a resist underlayer film, a laminate, a method for producing a semiconductor element, and a pattern forming method, each using the resist underlayer film-forming composition.

### Description of Embodiments

### (Resist underlayer film-forming composition)

The resist underlayer film-forming composition of the present invention contains a polymer (A) and a solvent (B).

The resist underlayer film-forming composition may contain a crosslinking agent (C), a curing catalyst (D), and the like.

The polymer (A) contains a phenolic hydroxy group and a nitro group.

When the resist underlayer film-forming composition contains the polymer (A) containing a phenolic hydroxy group and a nitro group, a good resist pattern with improved sensitivity and adhesion can be formed on the resist underlayer film formed from the resist underlayer film-forming composition. By improving the adhesion, even a fine resist pattern is less likely to collapse.

### <Polymer (A)>

The polymer (A) is not particularly limited as long as it contains a phenolic hydroxy group and a nitro group (-NO₂).

The phenolic hydroxy group refers to a hydroxy group bonded to an aromatic hydrocarbon ring. The aromatic hydrocarbon ring is not particularly limited, but a benzene ring, a naphthalene ring, and an anthracene ring are preferable from the viewpoint of more suitably obtaining the effect of the present invention.

The nitro group is bonded to, for example, an aromatic hydrocarbon ring. The aromatic hydrocarbon ring is not particularly limited, but a benzene ring, a naphthalene ring, and an anthracene ring are preferable from the viewpoint of more suitably obtaining the effect of the present invention.

The phenolic hydroxy group and the nitro group may be bonded to the same aromatic hydrocarbon ring or may be bonded to different aromatic hydrocarbon rings, but are preferably bonded to different aromatic hydrocarbon rings.

The polymer (A) is not particularly limited, and for example, addition polymerization polymers, polycondensation polymers, and ring-opening polymerization polymers, such as vinyl polymers, polyesters, polyimides, phenol novolacs, naphthol novolacs, polyethers, polyamides, and polycarbonates, can be used. Among them, a vinyl polymer is preferable from the viewpoint of more suitably obtaining the effect of the present invention.

The vinyl polymer is a polymer obtained by polymerizing a polymerizable unsaturated bond of a compound having a group with a polymerizable unsaturated bond. Examples of the group having a polymerizable unsaturated bond include a (meth)acryloyl group, a vinylaryl group (for example, a styryl group), a vinyloxy group, and an allyl group.

The vinyl polymer may be a homopolymer or a copolymer, but is preferably a copolymer from the viewpoint of more suitably obtaining the effect of the present invention.

From the viewpoint of suitably obtaining the effect of the present invention, the polymer (A) preferably contains at least one of a structural unit (A1) represented by formula (A1) below and a structural unit (A2) represented by formula (A2) below, and more preferably contains a structural unit (A1) represented by formula (A1) below and a structural unit (A2) represented by formula (A2) below. As the polymer containing at least one of the structural unit (A1) represented by formula (A1) below and the structural unit (A2) represented by formula (A2) below, a vinyl polymer is preferable.

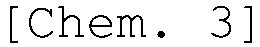

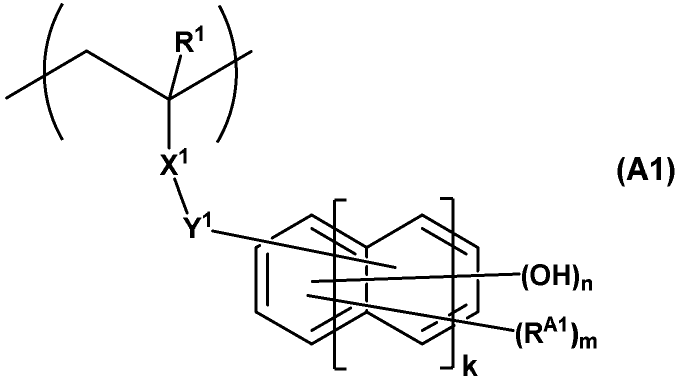

In the formula (A1), R¹ represents a hydrogen atom or a methyl group, X¹ represents a single bond, an ester bond or an amide bond, Y¹ represents a single bond or an alkylene group having 1 to 4 carbon atoms, R^{A1} represents a halogen atom, a carboxy group, a cyano group, a methylenedioxy group, an acetoxy group, a methylthio group, an amino group, an alkyl group having 1 to 9 carbon atoms or an alkoxy group having 1 to 9 carbon atoms, n represents an integer from 1 to 7, m represents an integer from 0 to 6, k represents an integer from 0 to 2, and when m is 2 or more, m R^{A1}'s may be the same or different.

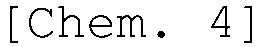

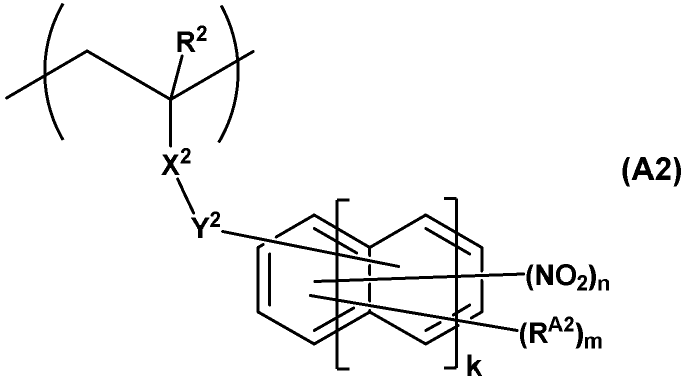

In the formula (A2), R² represents a hydrogen atom or a methyl group, X² represents a single bond, an ester bond or an amide bond, Y² represents a single bond or an alkylene group having 1 to 4 carbon atoms, R^{A2} represents a halogen atom, a carboxy group, a cyano group, a methylenedioxy group, an acetoxy group, a methylthio group, an amino group, an alkyl group having 1 to 9 carbon atoms or an alkoxy group having 1 to 9 carbon atoms, n represents an integer from 1 to 7, m represents an integer from 0 to 6, k represents an integer from 0 to 2, and when m is 2 or more, m R^{A2}'s may be the same or different.

When k in the formula (A1) is 0, n in the formula (A1) represents an integer from 1 to 5, and m in the formula (A1) represents an integer from 0 to 4.

When k in the formula (A2) is 0, n in the formula (A2) represents an integer from 1 to 5, and m in the formula (A2) represents an integer from 0 to 4.

n in the formula (A1) is preferably 1 to 5, more preferably 1 to 3, still more preferably 1 or 2, and particularly preferably 1.
n in the formula (A2) is preferably 1 to 5, more preferably 1 to 3, still more preferably 1 or 2, and particularly preferably 1.
m in the formula (A1) is preferably 0 to 4, more preferably 0 to 2, still more preferably 0 or 1, and particularly preferably 0.
m in the formula (A2) is preferably 0 to 4, more preferably 0 to 2, still more preferably 0 or 1, and particularly preferably 0.

Specific examples of the structural unit (A1) represented by formula (A1) include the following structural units.

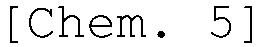

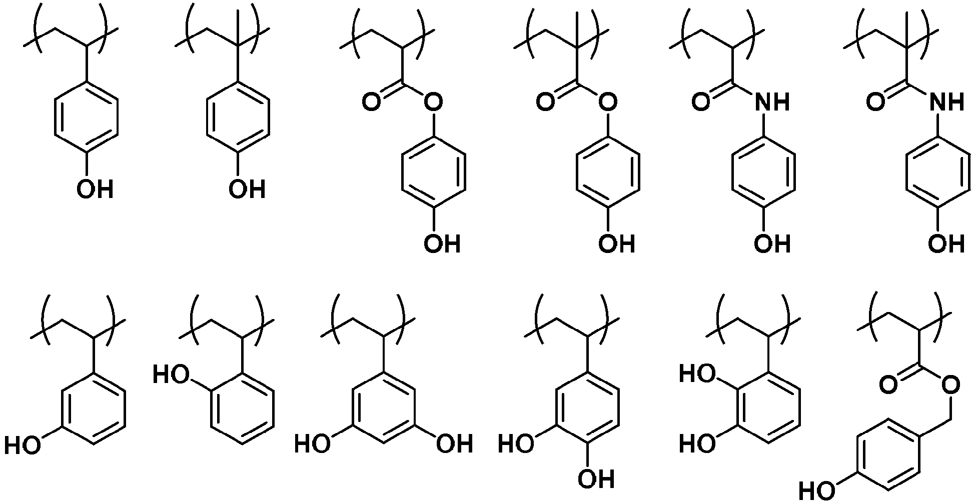

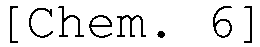

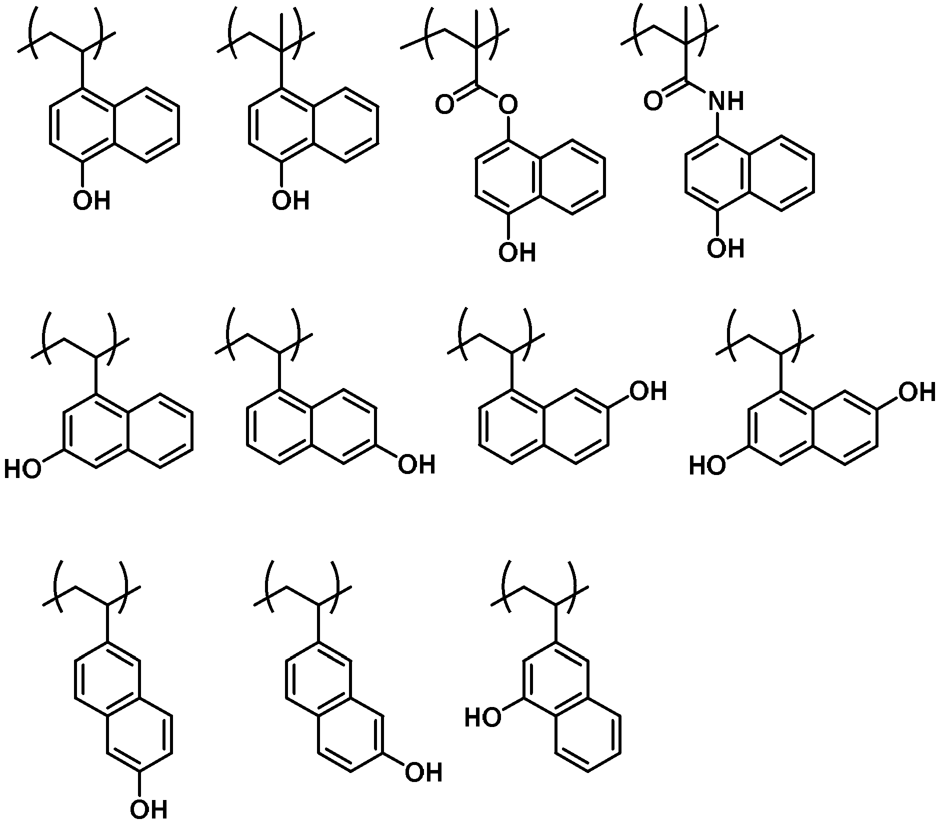

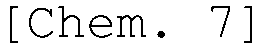

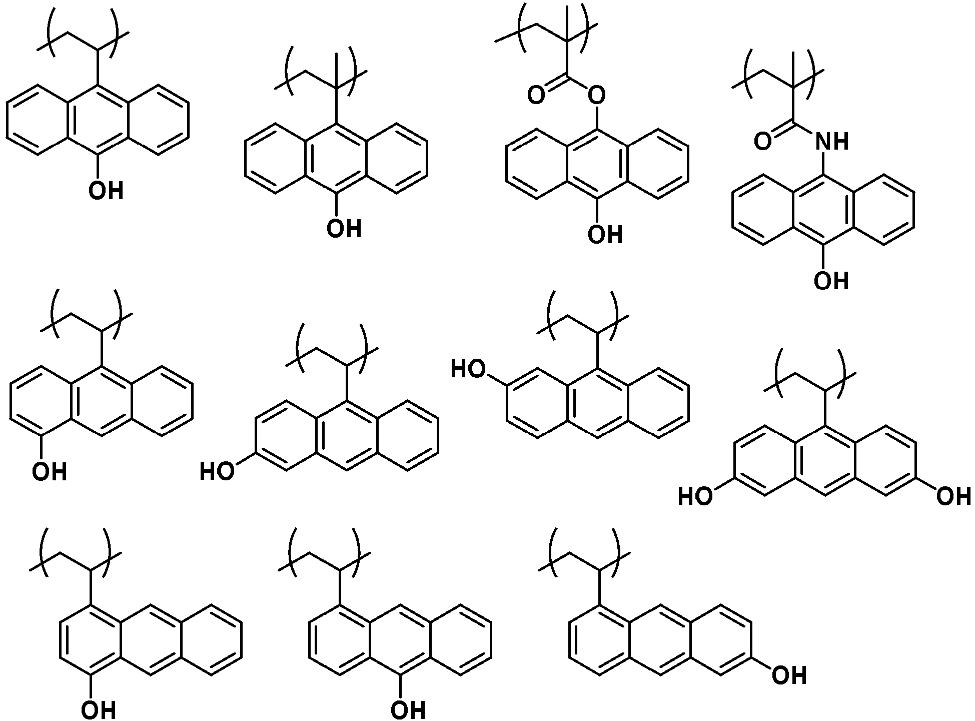

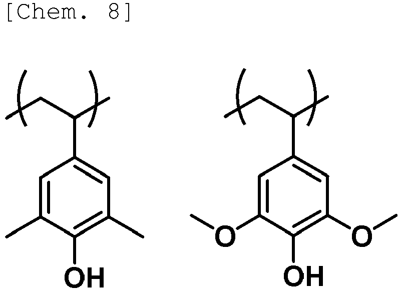

Specific examples of the structural unit (A2) represented by formula (A2) include the following structural units.

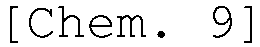

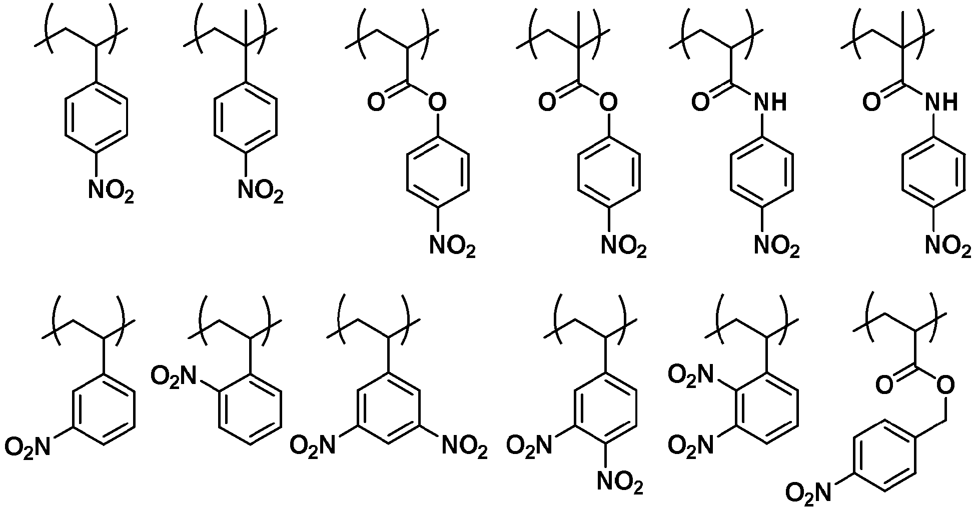

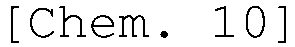

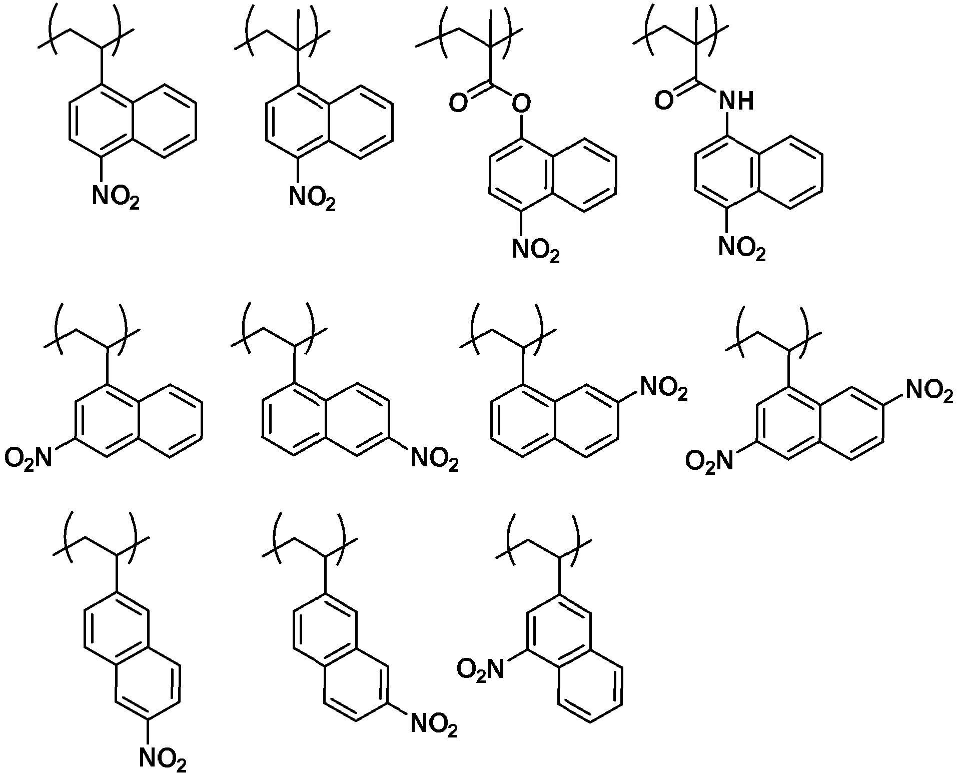

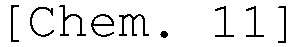

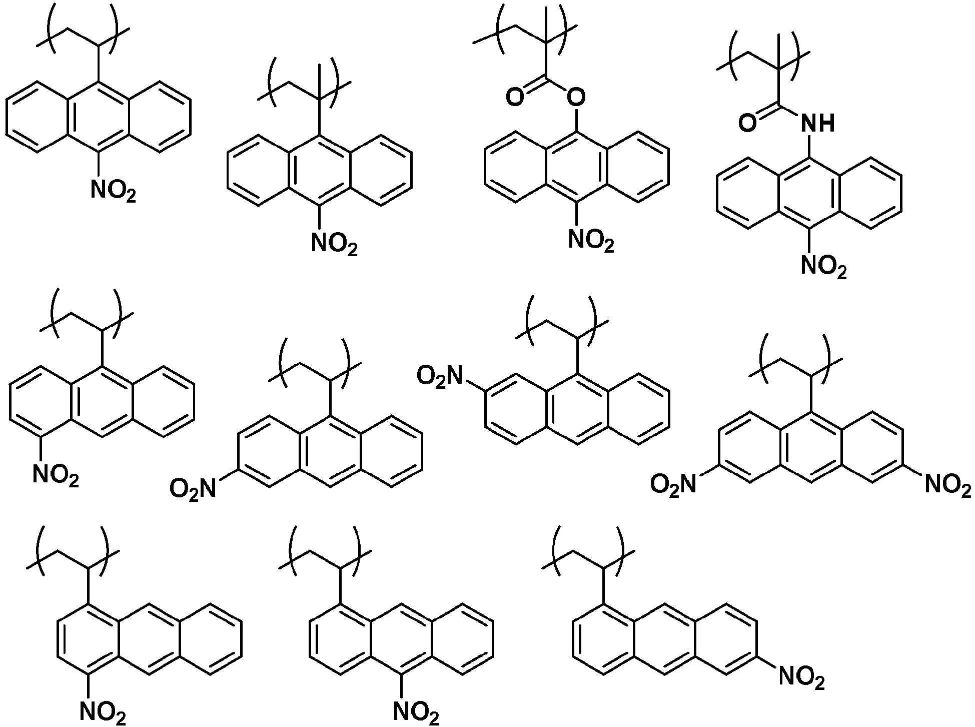

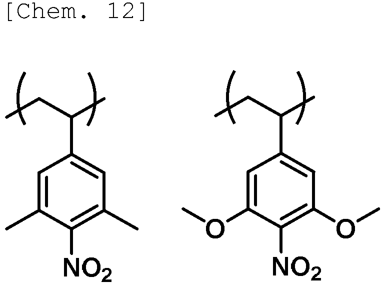

The polymer (A) may have a structural unit other than the structural unit (A1) represented by formula (A1) and the structural unit (A2) represented by formula (A2).

Examples of such a structural unit include a structural unit derived from a (meth)acrylic acid ester compound, a (meth)acrylamide compound, or a styrene compound.

In the present invention, the (meth)acrylic acid ester compound means an acrylic acid ester compound or a methacrylic acid ester compound. The same applies to the (meth)acrylamide compound.

Examples of the structural unit derived from the (meth)acrylic acid ester compound include a structural unit (B1) represented by formula (B1) below.

Examples of the structural unit derived from the (meth)acrylamide compound include a structural unit (B2) represented by formula (B2) below.

Examples of the structural unit derived from a styrene compound include a structural unit (B3) represented by formula (B3) below. 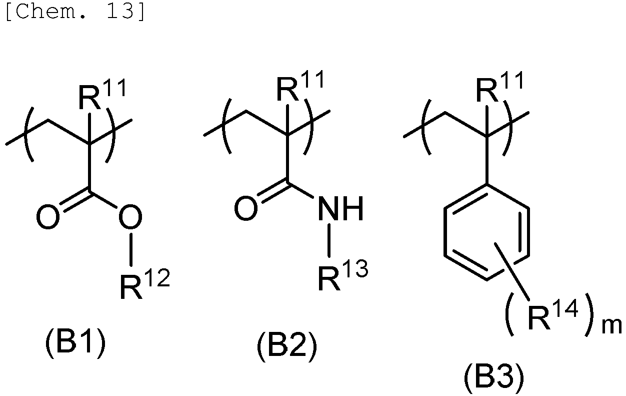 In the formulas (B1) to (B3), R¹¹ represents a hydrogen atom or an alkyl group having 1 to 3 carbon atoms, and R¹² represents a monovalent group having 1 to 20 carbon atoms. R¹³ represents a hydrogen atom or a monovalent group having 1 to 20 carbon atoms. R1⁴ each independently represents a halogen atom, a carboxy group, a cyano group, or a monovalent group having 1 to 10 carbon atoms. m represents an integer from 0 to 5.

The number of carbon atoms in R¹² and R¹³ may be 1 to 20 or 1 to 10.

The monovalent group having 1 to 20 carbon atoms in R¹² and R¹³ may have a heteroatom. Examples of the heteroatom include an oxygen atom and a nitrogen atom.

The monovalent group having 1 to 20 carbon atoms in R¹² and R¹³ may have an aromatic ring. Examples of the aromatic ring include an aromatic hydrocarbon ring and an aromatic heterocyclic ring. Examples of the aromatic hydrocarbon ring include a benzene ring and a naphthalene ring.

The monovalent group having 1 to 20 carbon atoms in R¹² and R¹³ may have, for example, a halogen atom, a hydroxy group, a carboxy group, a cyano group, an epoxy group, or the like.

Examples of the monovalent group having 1 to 20 carbon atoms in R¹² and R¹³ include an optionally substituted alkyl group and an optionally substituted aromatic group.

Examples of the substituent in the optionally substituted alkyl group include a halogen atom, a hydroxy group, a carboxy group, a cyano group, an epoxy group, and an optionally substituted aromatic group.

Examples of the substituent in the optionally substituted aromatic group include a halogen atom, a carboxy group, a cyano group, an epoxy group, an alkyl group having 1 to 6 carbon atoms which may be substituted with a halogen atom, and an alkoxy group having 1 to 6 carbon atoms which may be substituted with a halogen atom.

Examples of the alkyl group having 1 to 6 carbon atoms include a methyl group, an ethyl group, a propyl group, and a butyl group.

Examples of the alkoxy group having 1 to 6 carbon atoms include a methoxy group, an ethoxy group, a propoxy group, and a butoxy group.

The monovalent group having 1 to 10 carbon atoms in R¹⁴ may have a heteroatom. Examples of the heteroatom include an oxygen atom and a nitrogen atom.

The monovalent group having 1 to 10 carbon atoms in R¹⁴ may have, for example, a halogen atom, a hydroxy group, a carboxy group, a cyano group, an epoxy group, or the like.

Examples of the monovalent group having 1 to 10 carbon atoms in R¹⁴ include an alkyl group having 1 to 6 carbon atoms which may be substituted with a halogen atom, an alkoxy group having 1 to 6 carbon atoms which may be substituted with a halogen atom, and the like.

Examples of the alkyl group having 1 to 6 carbon atoms include a methyl group, an ethyl group, a propyl group, and a butyl group.

Examples of the alkoxy group having 1 to 6 carbon atoms include a methoxy group, an ethoxy group, a propoxy group, and a butoxy group.

Specific examples of the acrylic acid ester compound include, but are not limited to, methyl acrylate, ethyl acrylate, normal hexyl acrylate, i-propyl acrylate, cyclohexyl acrylate, benzyl acrylate, phenyl acrylate, anthrylmethyl acrylate, 2,2,2-trifluoroethyl acrylate, 2,2,2-trichloroethyl acrylate, 2-bromoethyl acrylate, 2-methoxyethyl acrylate, tetrahydrofurfuryl acrylate, 2-methyl-2-adamantyl acrylate, 3-acryloxypropyltriethoxysilane, and glycidyl acrylate.

Specific examples of the methacrylate ester compound include, but are not limited to, methyl methacrylate, ethyl methacrylate, normal hexyl methacrylate, i-propyl methacrylate, cyclohexyl methacrylate, benzyl methacrylate, phenyl methacrylate, anthrylmethyl methacrylate, 2,2,2-trifluoroethyl methacrylate, 2,2,2-trichloroethyl methacrylate, 2-bromoethyl methacrylate, 2-methoxyethyl methacrylate, tetrahydrofurfuryl methacrylate, 2-methyl-2-adamantyl methacrylate, 3-methacryloxypropyltriethoxysilane, glycidyl methacrylate, 2-phenylethyl methacrylate, bromophenyl methacrylate.

Specific examples of the acrylamide compound include, but are not limited to, acrylamide, N-methylacrylamide, N-ethylacrylamide, N-benzylacrylamide, N-phenylacrylamide, N,N-dimethylacrylamide, and N-anthrylacrylamide.

Specific examples of the methacrylamide compound include, but are not limited to, methacrylamide, N-methylmethacrylamide, N-ethylmethacrylamide, N-benzylmethacrylamide, N-phenylmethacrylamide, N,N-dimethylmethacrylamide, and N-anthrylmethacrylamide.

Specific examples of the styrene compound include, but are not limited to, styrene, chlorostyrene, bromostyrene, methoxystyrene, cyanostyrene, and acetylstyrene.

The polymer may further have other structural units. Examples of the monomers from which such a structural unit is derived include, but are not limited to, acrylic acid, methacrylic acid, a vinyl compound, a maleimide compound, maleic anhydride, and acrylonitrile.

Specific examples of the vinyl compound include, but are not limited to, vinyl alcohol, 2-hydroxyethyl vinyl ether, methyl vinyl ether, ethyl vinyl ether, benzyl vinyl ether, vinyl acetate, vinyltrimethoxysilane, 2-chloroethyl vinyl ether, 2-methoxyethyl vinyl ether, vinylnaphthalene, and vinylanthracene.

Examples of the maleimide compound include, but are not limited to, maleimide, N-methylmaleimide, N-phenylmaleimide, N-cyclohexylmaleimide, N-benzylmaleimide, and N-hydroxyethylmaleimide.

The lower limit value of the molar ratio of the structural unit (A1) represented by formula (A1) relative to all structural units of the polymer (A) is not particularly limited, but from the viewpoint of suitably obtaining the effect of the present invention, the molar ratio of the structural unit (A1) is preferably 20 mol% or more, more preferably 30 mol% or more, and particularly preferably 40 mol or more.

The upper limit value of the molar ratio of the structural unit (A1) represented by formula (A1) relative to all structural units of the polymer (A) is not particularly limited, but from the viewpoint of suitably obtaining the effect of the present invention, the molar ratio of the structural unit (A1) is preferably 90 mol% or less, more preferably 80 mol% or less, and particularly preferably 70 mol% or less.

The lower limit value of the molar ratio of the structural unit (A2) represented by formula (A2) relative to all structural units of the polymer (A) is not particularly limited, but from the viewpoint of suitably obtaining the effect of the present invention, the molar ratio of the structural unit (A2) is preferably 10 mol% or more, more preferably 20 mol% or more, and particularly preferably 30 mol or more.

The upper limit value of the molar ratio of the structural unit (A2) represented by formula (A2) relative to all structural units of the polymer (A) is not particularly limited, but from the viewpoint of suitably obtaining the effect of the present invention, the molar ratio of the structural unit (A2) is preferably 80 mol% or less, more preferably 70 mol% or less, and particularly preferably 60 mol% or less.

The molar ratio (A1 : A2) between the structural unit (A1) and the structural unit (A2) in the polymer (A) is not particularly limited, but is preferably 20 : 80 to 90 : 10, more preferably 30 : 70 to 80 : 20, and particularly preferably 40 : 60 to 70 : 30 from the viewpoint of suitably obtaining the effect of the present invention.

The molar ratio of the sum of the structural unit (A1) and the structural unit (A2) to all structural units of the polymer (A) is not particularly limited, but is preferably 70 mol% to 100 mol%, more preferably 80 mol% to 100 mol%, and particularly preferably 90 mol% to 100 mol% from the viewpoint of suitably obtaining the effect of the present invention.

The method for producing the polymer (A) is not particularly limited.

The polymer (A) can be produced by polymerizing a monomer by a conventional method, for example, bulk polymerization, solution polymerization, suspension polymerization, or emulsion polymerization. Solution polymerization is particularly preferred, in which case, for example, a polymerization initiator can be used to polymerize the monomer.

As the polymerization initiator, an organic peroxide or a diazo-based compound can be used.

Examples of the organic peroxide include diacyl peroxides, peroxydicarbonates, peroxyesters, and sulfonate peroxides.

Examples of the diacyl peroxides include diacetyl peroxide, diisobutyl peroxide, didecanoyl peroxide, benzoyl peroxide, and succinic acid peroxide.

Examples of the peroxydicarbonates include diisopropyl peroxydicarbonate, di-2-ethylhexyl peroxydicarbonate, and diallyl peroxydicarbonate.

Examples of the peroxyesters include tert-butyl peroxyisobutyrate, tert-butyl neodecanoate, and cumene peroxy neodecanoate.

Examples of the sulfonate peroxides include acetylcyclohexylsulfonyl peroxide.

Examples of the azo-based compounds include 2,2'-azobisisobutyronitrile, dimethyl 2,2'-azobis(isobutyrate), 4,4'-azobis(4-cyanovaleric acid), 2,2'-azobis(4-methoxy-2,4-dimethoxyvaleronitrile), and 2,2'-azobis(2-cyclopropylpropionitrile).

When it is desired to terminate the polymerization in a short time, it is preferable to use a polymerization initiator having a decomposition half-life at 80°C of 10 hours or less. As such a polymerization initiator, benzoyl peroxide and 2,2'-azobisisobutyronitrile are preferable, and 2,2'-azobisisobutyronitrile is more preferable.

The amount of the polymerization initiator used is, for example, 0.0001 to 0.2 equivalents, preferably 0.0005 to 0.1 equivalents, with respect to the total amount of monomers used.

The solvent used for the polymerization is not particularly limited as long as the solvent is a solvent that is not involved in the polymerization reaction and is compatible with the obtained polymer, and examples thereof include aromatic hydrocarbons, alicyclic hydrocarbons, aliphatic hydrocarbons, ketones, ethers, esters, amides, sulfoxides, alcohols, and polyhydric alcohol derivatives.

Examples of the aromatic hydrocarbons include benzene, toluene, and xylene.

Examples of the alicyclic hydrocarbons include cyclohexane.

Examples of the aliphatic hydrocarbons include n-hexane and n-octane.

Examples of the ketones include acetone, methyl ethyl ketone, and cyclohexanone.

Examples of the ethers include tetrahydrofuran and dioxane.

Examples of the esters include ethyl acetate and butyl acetate.

Examples of the amides include N,N-dimethylformamide and N,N-dimethylacetamide.

Examples of the sulfoxides include dimethyl sulfoxide.

Examples of the alcohols include methanol and ethanol.

Examples of the polyhydric alcohol derivatives include ethylene glycol monomethyl ether, propylene glycol monomethyl ether, ethylene glycol monomethyl ether acetate, and propylene glycol monomethyl ether acetate.

These compounds can be used alone or in combination of two or more.

The polymerization temperature is not particularly limited as long as it is within a temperature range in which side reactions such as transfer reactions or termination reactions do not occur and the monomer is consumed to complete the polymerization; however, the polymerization is preferably performed at a temperature ranging from -100°C to the boiling point of the solvent.

The concentration of the monomer in the solvent is not particularly limited, but is usually 1 to 40 mass%, and preferably 10 to 30 mass%.

The time for the polymerization reaction can be appropriately selected, and is usually in a range of 2 hours to 50 hours.

In addition, in order to facilitate polymerization, deprotection may be performed after polymerization is performed by protecting the functional group of the monomer.

Examples of the functional group to be protected include a phenolic hydroxy group. Examples of the protecting group include an acyl group (for example, an acetyl group). The deprotection can be performed, for example, by a hydrolysis reaction using an amine (for example, an organic amine).

The weight average molecular weight of the polymer (A) is not particularly limited, and is preferably 5,000 to 50,000, and more preferably 7,500 to 30,000. The weight average molecular weight is a value obtained by gel permeation chromatography (GPC) using polystyrene as a standard sample.

The content of the polymer (A) in the resist underlayer film-forming composition is not particularly limited, but from the viewpoint of suitably obtaining the effects of the present invention, the content is preferably 40 mass% to 100 mass%, more preferably 50 mass% to 95 mass%, and particularly preferably 60 mass% to 90 mass% relative to the film constituent components.

It should be noted that the film constituent components refer to the components other than the solvent in the resist underlayer film-forming composition.

### <Solvent (B)>

The solvent (B) is not particularly limited, and may be water or an organic solvent.

Examples of the organic solvent include an alkylene glycol monoalkyl ether and a monocarboxylic acid ester of an alkylene glycol monoalkyl ether.

Examples of the alkylene group of the alkylene glycol monoalkyl ether include an alkylene group having 2 to 4 carbon atoms.

Examples of the alkyl group of the alkylene glycol monoalkyl ether include an alkyl group having 1 to 4 carbon atoms.

The number of carbon atoms of the alkylene glycol monoalkyl ether is, for example, 3 to 8.

Examples of the alkylene glycol monoalkyl ether include ethylene glycol monomethyl ether, ethylene glycol monoethyl ether, propylene glycol monomethyl ether, and propylene glycol monoethyl ether.

Examples of the alkylene group of the monocarboxylic acid ester of the alkylene glycol monoalkyl ether include an alkylene group having 2 to 4 carbon atoms.

Examples of the alkyl group of the monocarboxylic acid ester of the alkylene glycol monoalkyl ether include an alkyl group having 1 to 4 carbon atoms.

Examples of the monocarboxylic acid of the monocarboxylic acid ester of the alkylene glycol monoalkyl ether include a saturated monocarboxylic acid having 2 to 4 carbon atoms.

Examples of the saturated monocarboxylic acid having 2 to 4 carbon atoms include acetic acid, propionic acid, and butyric acid.

The number of carbon atoms of the monocarboxylic acid ester of an alkylene glycol monoalkyl ether is, for example, 5 to 10.

Examples of the monocarboxylic acid ester of an alkylene glycol monoalkyl ether include methyl cellosolve acetate, ethyl cellosolve acetate, propylene glycol monomethyl ether acetate, and propylene glycol propyl ether acetate.

Examples of other organic solvents include diethylene glycol monomethyl ether, diethylene glycol monoethyl ether, propylene glycol, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, and N,N-dimethylacetamide.

Among these solvents (B), an alkylene glycol monoalkyl ether and a monocarboxylic acid ester of an alkylene glycol monoalkyl ether are preferred.

One type of these solvents (B) can be used alone or two or more types thereof can be used in combination.

The mass ratio of the organic solvent in the solvent (B) is not particularly limited, and is preferably 50 mass% to 100 mass%.

The content of the solvent (B) in the resist underlayer film-forming composition is not particularly limited, and is preferably 50 mass% to 99.99 mass%, more preferably 75 mass% to 99.95 mass%, and particularly preferably 90 mass% to 99.9 mass%.

### <Crosslinking agent (C)>

The crosslinking agent (C) is not particularly limited.

The crosslinking agent (C) has a structure different from that of the polymer (A).

As the crosslinking agent (C), an aminoplast crosslinking agent and a phenoplast crosslinking agent are preferred.

The aminoplast crosslinking agent is an addition condensate of a compound having an amino group, such as melamine or guanamine, and formaldehyde.

The phenoplast crosslinking agent is an addition condensate of a compound having a phenolic hydroxy group and formaldehyde.

Examples of the crosslinking agent (C) include a compound having two or more structures shown below.

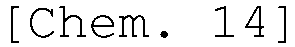

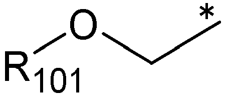

In the structure, R₁₀₁ represents a hydrogen atom, an alkyl group having 1 to 4 carbon atoms, or an alkoxyalkyl group having 2 to 6 carbon atoms. * represents a bonding site.

The bonding site is bonded to, for example, a nitrogen atom, a carbon atom constituting an aromatic hydrocarbon ring, or the like.

As R₁₀₁, a hydrogen atom, a methyl group, an ethyl group, or a group represented by the following structure is preferable.

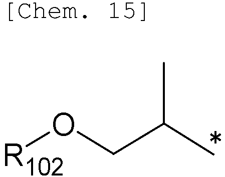

In the structure, R₁₀₂ represents a hydrogen atom, a methyl group, or an ethyl group. * represents a bonding site.

The crosslinking agent (C) is preferably a melamine compound, a guanamine compound, a glycoluril compound, a urea compound, or a compound having a phenolic hydroxy group. These compounds can be used alone or in combination of two or more.

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, and a compound in which 1 to 6 methylol groups of hexamethylolmelamine are acyloxymethylated or a mixture thereof.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

Examples of the glycoluril compound include tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof.

The glycoluril compound may be, for example, a glycoluril derivative represented by formula (1E) below.

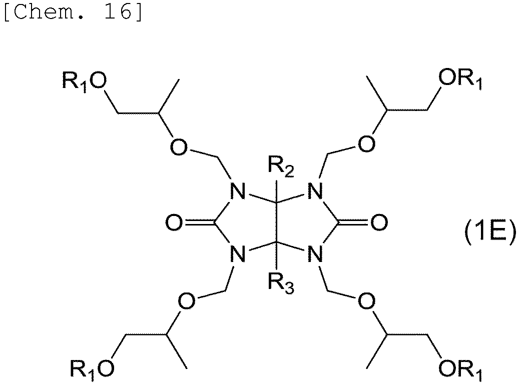

In the formula (1E), four R₁ each independently represent a methyl group or an ethyl group, and R₂ and R₃ each independently represent a hydrogen atom, an alkyl group having 1 to 4 carbon atoms, or a phenyl group.

Examples of the glycoluril derivative represented by the formula (1E) include compounds represented by formulas (1E-1) to (1E-6) below.

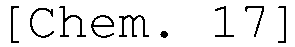

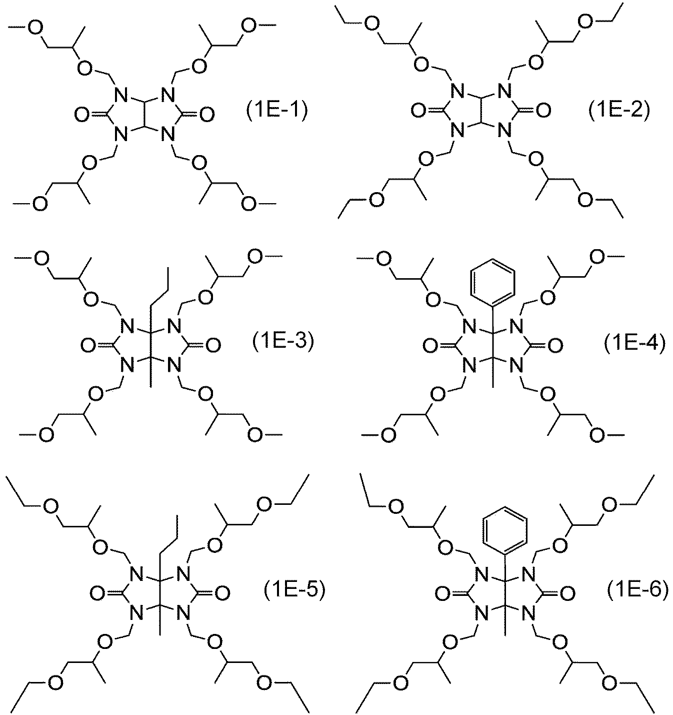

The glycoluril derivative represented by formula (1E) is obtained, for example, by a reaction of a glycoluril derivative represented by formula (2E) below with at least one compound represented by formula (3d) below. 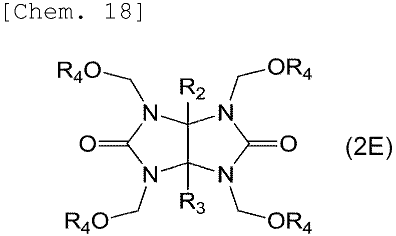 In the formula (2E), R₂ and R₃ each independently represent a hydrogen atom, an alkyl group having 1 to 4 carbon atoms, or a phenyl group, and R₄'s each independently represent an alkyl group having 1 to 4 carbon atoms. 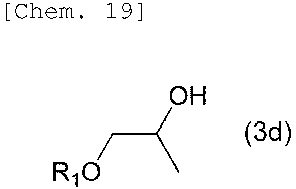 In the formula (3d), R₁ represents a methyl group or an ethyl group.

Examples of the glycoluril derivative represented by the formula (2E) include compounds represented by formulas (2E-1) to (2E-4) below. Examples of the compound represented by the formula (3d) include compounds represented by formulas (3d-1) and (3d-2) below.

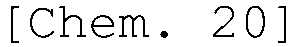

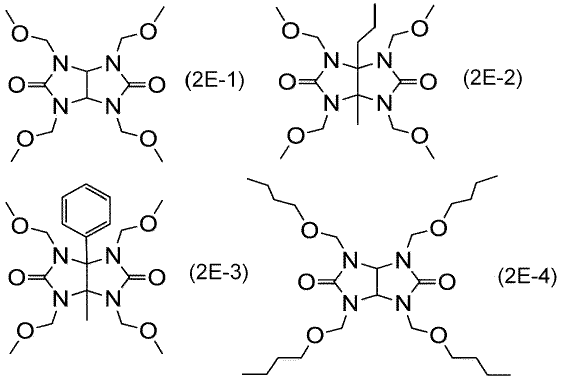

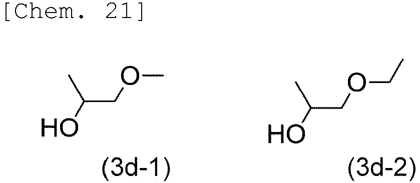

Examples of the urea compound include tetramethylolurea, tetramethoxymethylurea, a compound in which 1 to 4 methylol groups of tetramethylolurea are methoxymethylated or a mixture thereof, and tetramethoxyethylurea.

Examples of the compound having a phenolic hydroxy group include a compound represented by formula (G-1) or formula (G-2) below.

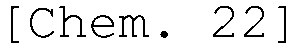

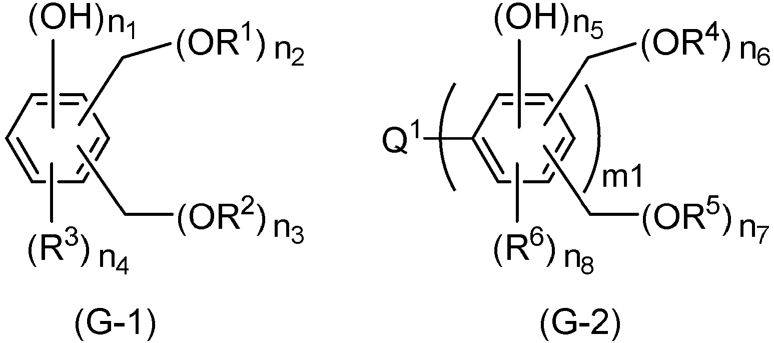

In the formulas (G-1) and (G-2), Q¹ represents a single bond or an m1-valent organic group,
R¹ and R⁴ each represent an alkyl group having 2 to 10 carbon atoms or an alkyl group having 2 to 10 carbon atoms and having an alkoxy group having 1 to 10 carbon atoms,
R² and R⁵ each represent a hydrogen atom or a methyl group,
R³ and R⁶ each represent an alkyl group having 1 to 10 carbon atoms or an aryl group having 6 to 40 carbon atoms,
n₁ represents an integer satisfying 1 ≤ n₁ ≤ 3, n₂ represents an integer satisfying 2 ≤ n₂≤ 5, n₃ represents an integer satisfying 0 ≤ n₃ ≤ 3, n₄ represents an integer satisfying 0 ≤ n₄ ≤ 3, and 3 ≤ (n₁ + n₂ + n₃ + n₄) ≤ 6,
n₃ represents an integer satisfying 1 ≤ n₅ ≤ 3, n₆ represents an integer satisfying 1 ≤ n₆ ≤ 4, n₇ represents an integer satisfying 0 ≤ n₇ ≤ 3, n₈ represents an integer satisfying 0 ≤ n₈ ≤ 3, and 2 ≤ (n₅ + n₆ + n₇ + n₈) ≤ 5, and
m1 represents an integer from 2 to 10.

Examples of the compound having a phenolic hydroxy group include a compound represented by formula (G-3) or formula (G-4) below.

The compound represented by formula (G-1) or formula (G-2) may be obtained by a reaction of a compound represented by formula (G-3) or formula (G-4) below with a hydroxyl group-containing ether compound or an alcohol having 2 to 10 carbon atoms.

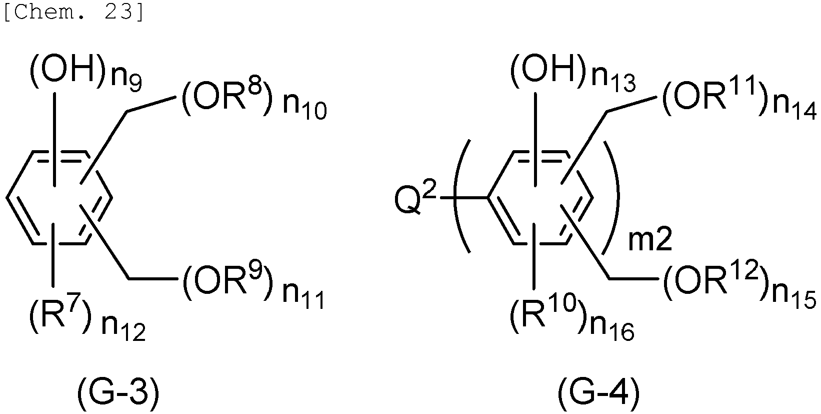

In the formulas (G-3) and (G-4), Q² represents a single bond or an m2-valent organic group,
R⁸, R⁹, R¹¹, and R¹² each represent a hydrogen atom or a methyl group,
R⁷ and R¹⁰ each represent an alkyl group having 1 to 10 carbon atoms or an aryl group having 6 to 40 carbon atoms,
n₉ represents an integer satisfying 1 ≤ ng ≤ 3, n₁₀ represents an integer satisfying 2 ≤ n₁₀ ≤ 5, n₁₁ represents an integer satisfying 0 ≤ n₁₁ ≤ 3, n₁₂ represents an integer satisfying 0 ≤ n₁₂ ≤ 3, and 3 ≤ (n₉ + n₁₀ + n₁₁ + n₁₂) ≤ 6,
n₁₃ represents an integer satisfying 1 ≤ n₁₃ ≤ 3, n₁₄ represents an integer satisfying 1 ≤ n₁₄ ≤ 4, n₁₅ represents an integer satisfying 0 ≤ n₁₅ ≤ 3, and n₁₆ represents an integer satisfying 0 ≤ n₁₆ ≤ 3, and 2 ≤ (n₁₃ + n₁₄ + n₁₅ + n₁₆) ≤ 5, and
m2 represents an integer from 2 to 10.

Examples of the m2-valent organic group of Q² include an m2-valent organic group having 1 to 15 carbon atoms.

Examples of the compound represented by the formula (G-1) or the formula (G-2) include the following compounds.

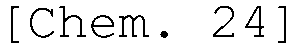

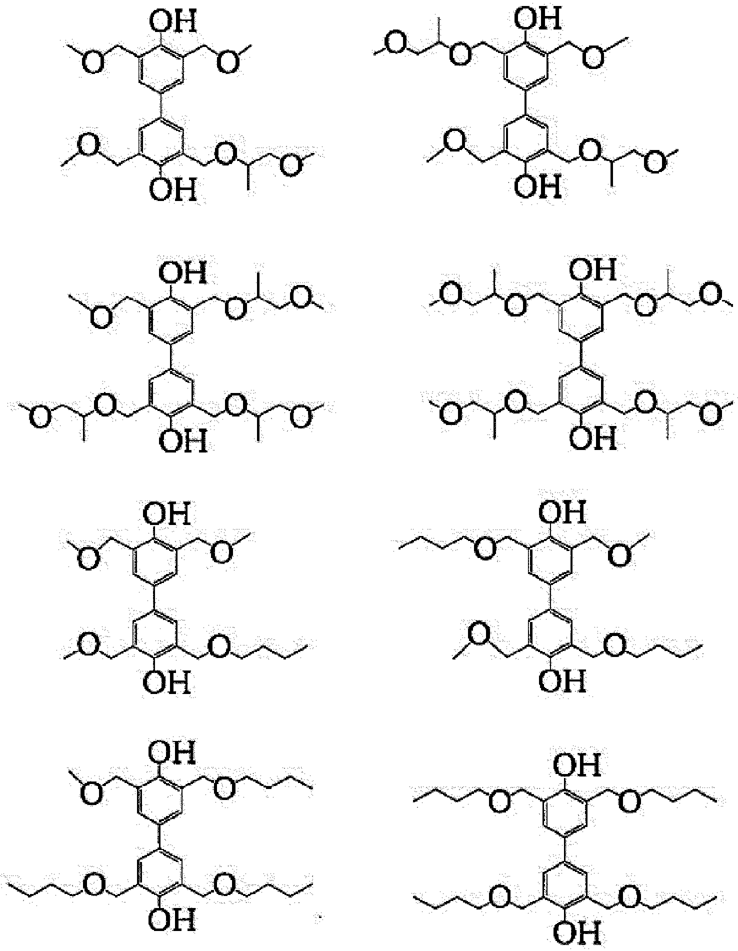

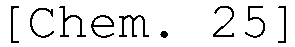

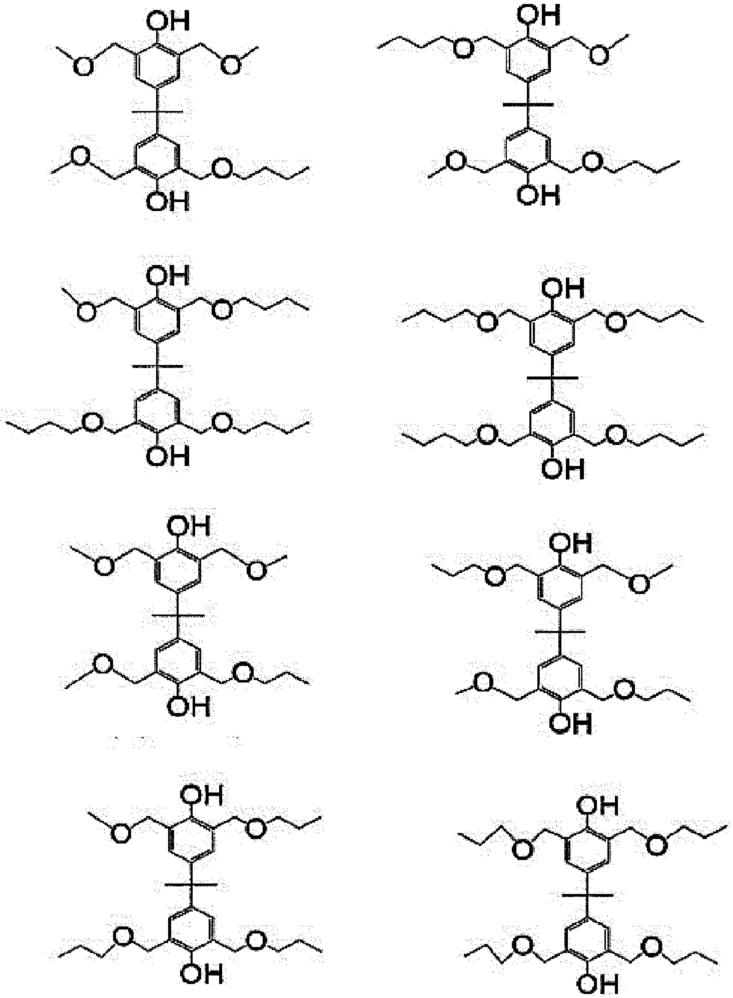

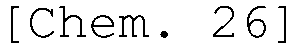

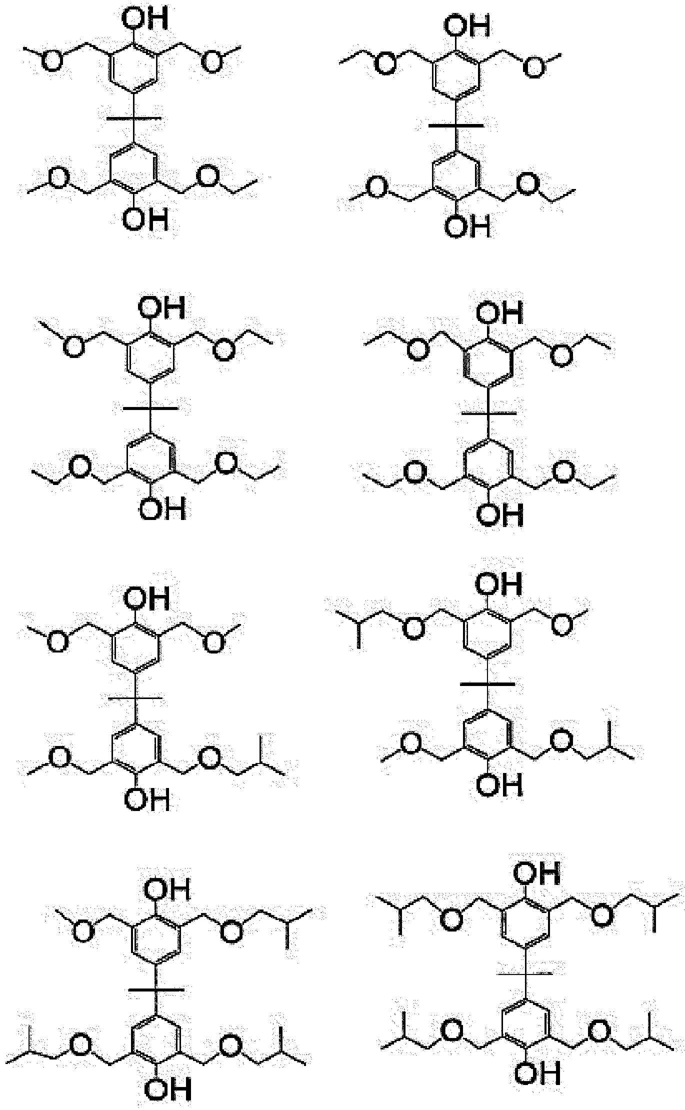

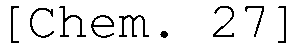

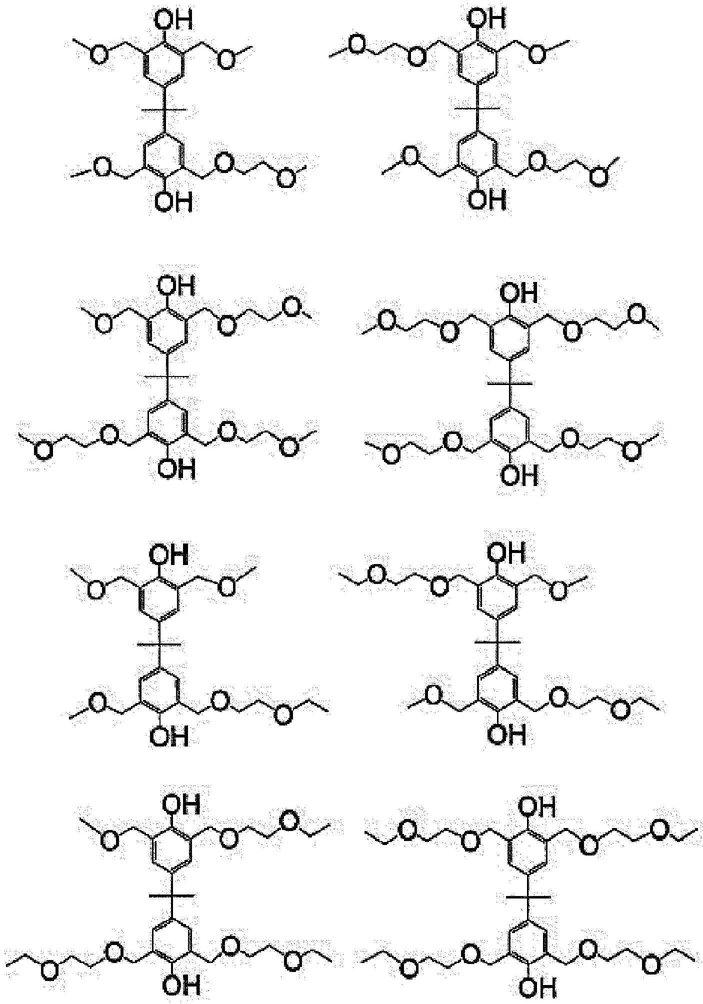

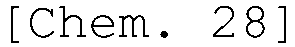

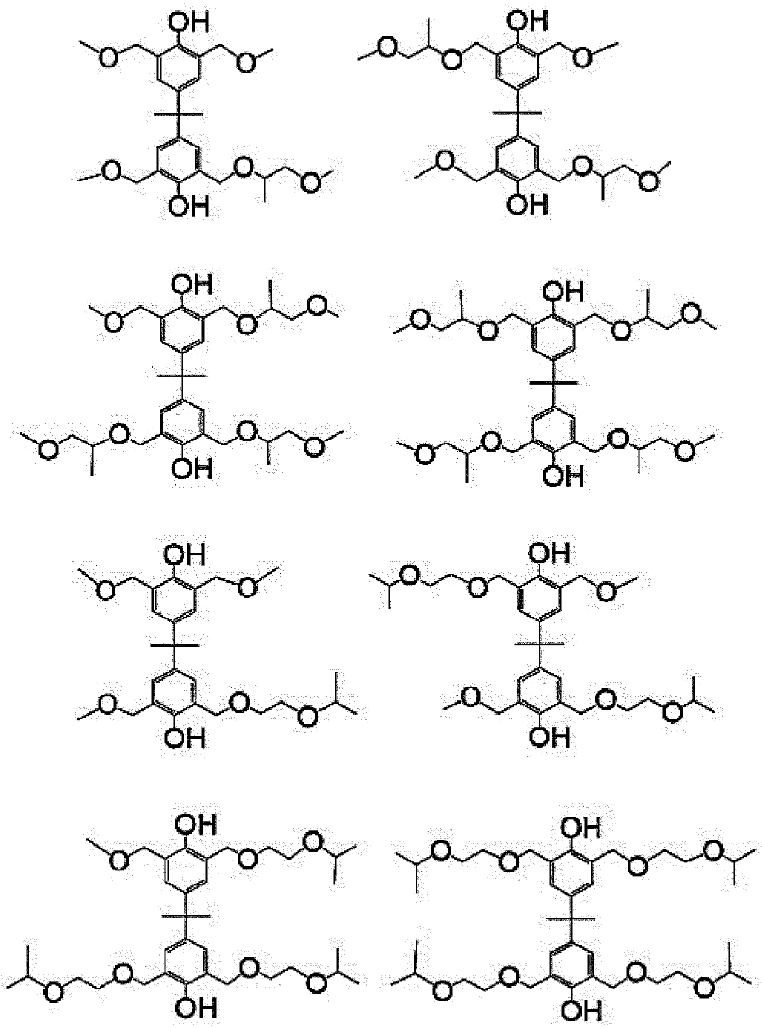

Examples of the compound represented by the formula (G-3) or the formula (G-4) include the following compounds.

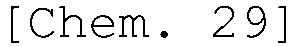

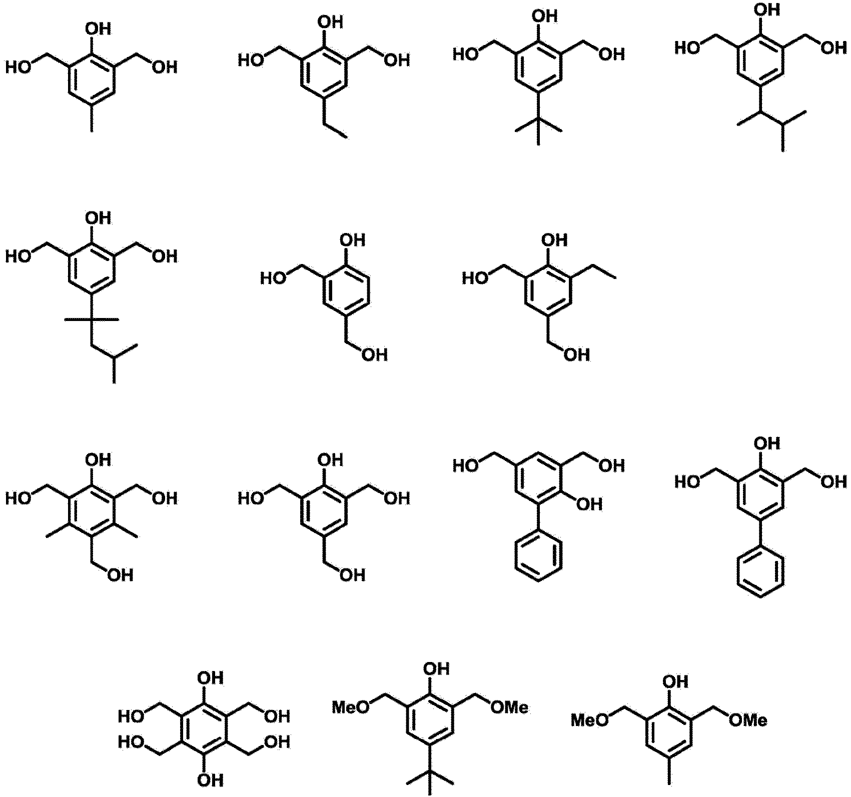

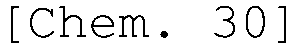

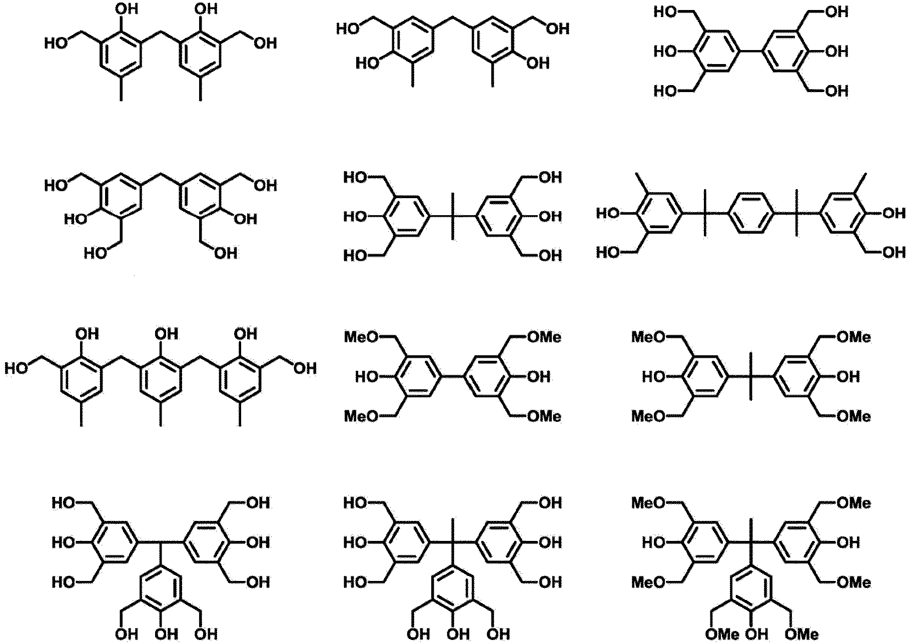

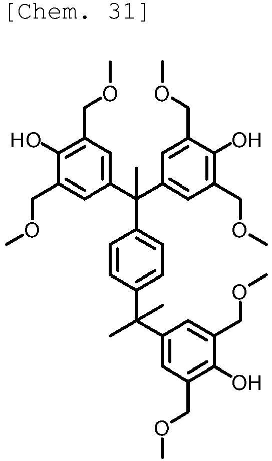

Me represents a methyl group.

The compounds are available as products of Asahi Organic Chemicals Industry Co., Ltd. and Honshu Chemical Industry Co., Ltd. Examples of the product include trade names TMOM-BP and HMOM-TPPA manufactured by Asahi Organic Chemicals Industry Co., Ltd.

Among the compounds, the glycoluril compound is preferred. Specifically, tetramethylol glycoluril, tetramethoxy glycoluril, tetramethoxymethyl glycoluril, a compound in which 1 to 4 methylol groups of tetramethylol glycoluril are methoxymethylated or a mixture thereof, and a compound in which 1 to 4 methylol groups of tetramethylol glycoluril are acyloxymethylated or a mixture thereof are preferred, and tetramethoxymethyl glycoluril is more preferred.

The molecular weight of the crosslinking agent (C) is not particularly limited, and is preferably 500 or less.

The content of the crosslinking agent (C) in the resist underlayer film-forming composition is not particularly limited, and is, for example, 1 mass% to 70 mass%, and preferably 5 mass% to 60 mass% with respect to the polymer (A).

### <Curing Catalyst (D)>

As the curing catalyst (D) contained as an optional component in the resist underlayer film-forming composition, both a thermal acid generator and a photoacid generator can be used, and a thermal acid generator is preferably used.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium phenolsulfonate, pyridinium p-hydroxybenzenesulfonate (p-phenolsulfonic acid pyridinium salt), pyridinium-trifluoromethanesulfonate, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, hydroxybenzoic acid, N-methylmorpholine-p-toluenesulfonate, N-methylmorpholine-p-hydroxybenzenesulfonate, and N-methylmorpholine-5-sulfosalicylate.

Examples of the photoacid generator include onium salt compounds, sulfonimide compounds, and disulfonyldiazomethane compounds.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, and sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compounds include N-(trifluoromethanesulfonyloxy) succinimide, N-(nonafluoronormalbutanesulfonyloxy) succinimide, N-(camphorsulfonyloxy) succinimide, and N-(trifluoromethanesulfonyloxy) naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

As the curing catalyst (D), only one type can be used, or two or more types can be used in combination.

In a case where the curing catalyst (D) is used, the content ratio of the curing catalyst (D) is, for example, 0.1 mass% to 50 mass%, and preferably 1 mass% to 30 mass% with respect to the crosslinking agent (C).

### <Other Components>

To the resist underlayer film-forming composition, a surfactant can be further added in order to further improve the coatability against surface unevenness without generating a pinhole, a striation, and the like.

Examples of the surfactant include linear or branched alkylbenzenesulfonic acids (such as dodecylbenzenesulfonic acid); polyoxyethylene alkyl ethers such as polyoxyethylene lauryl ether, polyoxyethylene stearyl ether, polyoxyethylene cetyl ether, and polyoxyethylene oleyl ether; polyoxyethylene alkyl aryl ethers such as polyoxyethylene octylphenol ether and polyoxyethylene nonylphenol ether; polyoxyethylene/polyoxypropylene block copolymers; sorbitan fatty acid esters such as sorbitan monolaurate, sorbitan monopalmitate, sorbitan monostearate, sorbitan monooleate, sorbitan trioleate, and sorbitan tristearate; nonionic surfactants of polyoxyethylene sorbitan fatty acid esters and the like such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants such as EFTOP EF301, EF303, and EF352 (manufactured by TOHKEM PRODUCTS Corporation, trade names); MEGAFACE F171, F173, and R-30 (manufactured by DIC Corporation, trade names); Fluorad FC430 and FC431 (manufactured by Sumitomo 3M Limited, trade names); AsahiGuard AG710 and Surflon S-382, SC101, SC102, SC103, SC104, SC105, and SC106 (manufactured by AGC Corporation, trade names); and organosiloxane polymer KP341 (manufactured by Shin-Etsu Chemical Co., Ltd.).

The blending amount of such a surfactant is usually 2.0 mass% or less, and preferably 1.0 mass% or less with respect to the total solid content of the resist underlayer film-forming composition.

These surfactants may be added alone, or two or more types thereof can also be added in combination.

The amount of the solid content in the resist underlayer film-forming composition of the present invention, that is, the amount of the components excluding the solvent is, for example, 0.01 mass% to 10 mass%.

The resist underlayer film-forming composition is preferably used for EUV lithography.

The resist underlayer film-forming composition is preferably used for forming an underlayer film of a metal-containing resist.

### (Resist Underlayer Film)

The resist underlayer film of the present invention is a cured product of the above-described resist underlayer film-forming composition.

The resist underlayer film can be produced, for example, by applying the above-described resist underlayer film-forming composition on a semiconductor substrate and baking the composition.

Examples of the semiconductor substrate to which the resist underlayer film-forming composition is to be applied include a silicon wafer, a germanium wafer, and compound semiconductor wafers such as gallium arsenide, indium phosphide, gallium nitride, indium nitride, and aluminum nitride.

When a semiconductor substrate having an inorganic film formed on a surface thereof is used, the inorganic film is formed by, for example, an atomic layer deposition (ALD) method, a chemical vapor deposition (CVD) method, a reactive sputtering method, an ion plating method, a vacuum deposition method, or a spin coating method (spin on glass: SOG). Examples of the inorganic film include a polysilicon film, a silicon oxide film, a silicon nitride film, a boro-phospho silicate glass (BPSG) film, a titanium nitride film, a titanium oxynitride film, a tungsten film, a gallium nitride film, and a gallium arsenide film.

On such a semiconductor substrate, the resist underlayer film-forming composition of the present invention is applied by an appropriate coating method such as a spinner or a coater. Thereafter, baking is performed using a heating unit such as a hot plate to form a resist underlayer film. The baking conditions are appropriately selected from a baking temperature of 100°C to 400°C and a baking time of 0.3 minutes to 60 minutes. Preferably, the baking temperature is 120°C to 350°C and the baking time is 0.5 minutes to 30 minutes, and more preferably, the baking temperature is 150°C to 300°C and the baking time is 0.8 minutes to 10 minutes.

The film thickness of the resist underlayer film is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (3 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), 0.005 µm (5 nm) to 0.02 µm (20 nm), 0.003 µm (3 nm) to 0.01 µm (10 nm), 0.005 µm (5 nm) to 0.01 µm (10 nm), 0.003 µm (3 nm) to 0.006 µm (6 nm), or 0.005 µm (5 nm).

The method of measuring the film thickness of the resist underlayer film in the specification is as follows.
· Measurement device name: Ellipsometric film thickness measurement device RE-3100 (SCREEN Semiconductor Solutions Co., Ltd.)
· Single wavelength ellipsometer (SWE) mode
· Arithmetic average of 8 points (for example, measurement was performed at 8 points at intervals of 1 cm in the wafer X direction)

### (Laminate)

A laminate of the present invention includes a semiconductor substrate and the resist underlayer film of the present invention.

Examples of the semiconductor substrate include the semiconductor substrates described above.

The resist underlayer film is disposed on, for example, a semiconductor substrate.

### (Method for Producing Semiconductor Element, and Pattern Forming Method)

The method for producing a semiconductor element of the present invention includes at least the following steps.
· a step of forming a resist underlayer film on a semiconductor substrate using the resist underlayer film-forming composition of the present invention; and
· a step of forming a resist film on the resist underlayer film.

The pattern forming method of the present invention includes at least the following steps:
· a step of forming a resist underlayer film on a semiconductor substrate using the resist underlayer film-forming composition of the present invention;
· a step of forming a resist film on the resist underlayer film;
· a step of irradiating the resist film with light or an electron beam, and then developing the resist film to obtain a resist pattern; and
· a step of etching a resist underlayer film with the resist pattern used as a mask.

The resist film is usually formed on the resist underlayer film.

The film thickness of the resist film is, for example, 3,000 nm or less, 2,000 nm or less, 1,800 nm or less, 1,500 nm or less, or 1,000 nm or less. The lower limit is 100 nm, 80 nm, 50 nm, 30 nm, 20 nm, or 10 nm.

The resist film formed on the resist underlayer film by a known method (for example, application and baking of a resist composition) is not particularly limited as long as it responds to light or an electron beam (EB) used for irradiation. Both a negative photoresist and a positive photoresist can be used.

In the present description, a resist that responds to an EB is also referred to as a photoresist.

Examples of the photoresist include a positive photoresist made of a novolac resin and 1,2-naphthoquinonediazide sulfonic acid ester, a chemically amplified photoresist made of a binder having a group, which is decomposed by an acid to increase the alkali dissolution rate, and a photoacid generator, a chemically amplified photoresist made of a low molecular compound, which is decomposed by an acid to increase the alkali dissolution rate of the photoresist, an alkali-soluble binder, and a photoacid generator, a chemically amplified photoresist made of a binder having a group, which is decomposed by an acid to increase the alkali dissolution rate, a low molecular compound, which is decomposed by an acid to increase the alkali dissolution rate of the photoresist, and a photoacid generator, and a resist containing a metal element. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, and AR2772 and SEPR430 (trade names) manufactured by Shin-Etsu Chemical Co., Ltd. Furthermore, examples thereof include fluorine atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

So-called resist compositions such as resist compositions, radiation-sensitive resin compositions, high-resolution patterning compositions based on organometallic solutions, and metal-containing resist compositions, which are disclosed in WO2019/188595 A, WO2019/187881 A, WO2019/187803 A, WO2019/167737 A, WO2019/167725 A, WO2019/187445 A, WO2019/167419 A, WO2019/123842 A, WO2019/054282 A, WO2019/058945 A, WO2019/058890 A, WO2019/039290 A, WO2019/044259 A, WO2019/044231 A, WO2019/026549 A, WO2018/193954 A, WO2019/172054 A, WO2019/021975 A, WO2018/230334 A, WO2018/194123 A, JP 2018-180525 A, WO2018/190088 A, JP 2018-070596 A, JP 2018-028090 A, JP 2016-153409 A, JP 2016-130240 A, JP 2016-108325 A, JP 2016-047920 A, JP 2016-035570 A, JP 2016-035567 A, JP 2016-035565 A, JP 2019-101417 A, JP 2019-117373 A, JP 2019-052294 A, JP 2019-008280 A, JP 2019-008279 A, JP 2019-003176 A, JP 2019-003175 A, JP 2018-197853 A, JP 2019-191298 A, JP 2019-061217 A, JP 2018-045152 A, JP 2018-022039 A, JP 2016-090441 A, JP 2015-10878 A, JP 2012-168279 A, JP 2012-022261 A, JP 2012-022258 A, JP 2011-043749 A, JP 2010-181857 A, JP 2010-128369 A, WO2018/031896 A, JP 2019-113855 A, WO2017/156388 A, WO2017/066319 A, JP 2018-41099 A, WO2016/065120 A, WO2015/026482 A, JP 2016-29498 A, and JP 2011-253185 A, can be used, but are not limited to these.

Examples of the resist composition include the following compositions.

An actinic ray-sensitive or radiation-sensitive resin composition containing resin A having a repeating unit having an acid-decomposable group, in which a polar group is protected by a protecting group removable by action of an acid, and a compound represented by the following general formula (121).

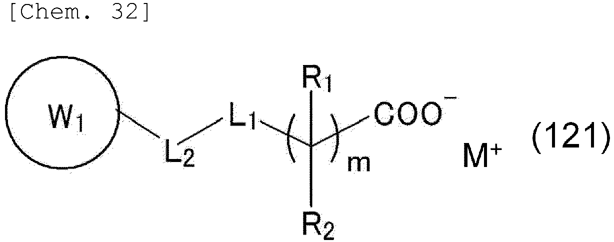

In the general formula (121), m represents an integer from 1 to 6,
R₁ and R₂ each independently represent a fluorine atom or a perfluoroalkyl group,
L₁ represents -O-, -S-, -COO-, -SO₂-, or -SO₃-,
L₂ represents an alkylene group which may have a substituent, or a single bond,
W₁ represents a cyclic organic group that may have a substituent, and
M⁺ represents a cation.

A metal-containing film forming composition for lithography with extreme ultraviolet ray or electron beam, containing a compound having a metal-oxygen covalent bond, and a solvent, in which the metal element of the above compound belongs to Periods 3 to 7 of Groups 3 to 15 of the periodic table.

A radiation-sensitive resin composition containing a polymer having a first structural unit represented by formula (31) below and a second structural unit represented by formula (32) below and containing an acid-dissociable group; and an acid generator.

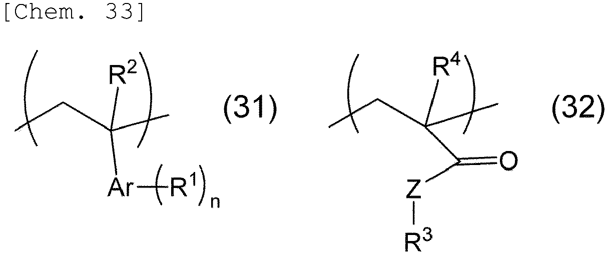

In the formula (31), Ar is a group obtained by removing (n + 1) hydrogen atoms from an arene having 6 to 20 carbon atoms, R¹ is a hydroxy group, a sulfanyl group, or a monovalent organic group having 1 to 20 carbon atoms, n is an integer from 0 to 11, when n is 2 or more, a plurality of R¹'s are identical or different, and R² is a hydrogen atom, a fluorine atom, a methyl group, or a trifluoromethyl group. In the formula (32), R³ is a monovalent group having 1 to 20 carbon atoms and containing the acid-dissociable group, Z is a single bond, an oxygen atom, or a sulfur atom, and R⁴ is a hydrogen atom, a fluorine atom, a methyl group, or a trifluoromethyl group.

A resist composition containing a resin (A1) containing a structural unit having a cyclic carbonate structure, a structural unit represented by the following formula, and a structural unit having an acid-labile group; and an acid generator.

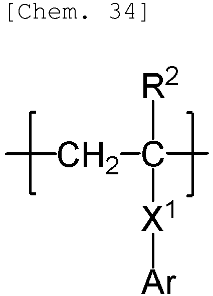

In the formula,
R² represents an alkyl group which has 1 to 6 carbon atoms and may have a halogen atom or represents a hydrogen atom or a halogen atom, X¹ represents a single bond, -CO-O-*, or -CO-NR⁴-*, * represents a bond with -Ar, R⁴ represents a hydrogen atom or an alkyl group having 1 to 4 carbon atoms, and Ar represents an aromatic hydrocarbon group which has 6 to 20 carbon atoms and may have one or more groups selected from the group consisting of a hydroxy group and a carboxy group.

Examples of the resist film include the following films.

A resist film containing a base resin containing a repeating unit represented by formula (a1) below and/or a repeating unit represented by formula (a2) below, and a repeating unit that generates an acid bound to a polymer main chain by light exposure.

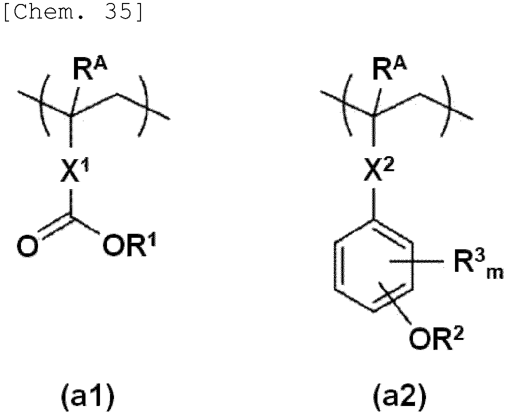

In the formulas (a1) and (a2), R^{A}'s are each independently a hydrogen atom or a methyl group, R¹ and R² are each independently a tertiary alkyl group having 4 to 6 carbon atoms, R³'s are each independently a fluorine atom or a methyl group, m is an integer from 0 to 4, X¹ is a single bond, a phenylene group, a naphthylene group, or a linking group having 1 to 12 carbon atoms and including at least one type selected from an ester bond, a lactone ring, a phenylene group, and a naphthylene group, and X² is a single bond, an ester bond, or an amide bond.

Examples of the resist material include the following materials.

A resist material containing a polymer having a repeating unit represented by formula (b1) or formula (b2) below.

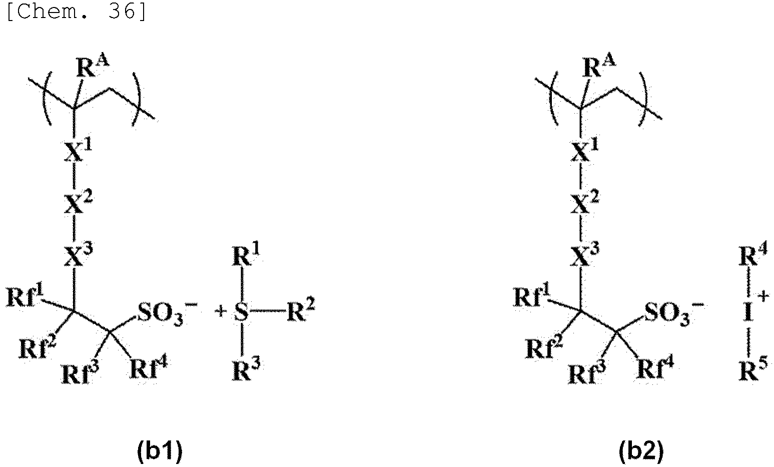

In the formulas (b1) and (b2), R^{A} is a hydrogen atom or a methyl group, X¹ is a single bond or an ester group, X² is a linear, branched, or cyclic alkylene group having 1 to 12 carbon atoms or an arylene group having 6 to 10 carbon atoms, and some of methylene groups included in the alkylene group may be substituted with an ether group, an ester group, or a lactone ring-containing group, and at least one hydrogen atom included in X² is substituted with a bromine atom, X³ is a single bond, an ether group, an ester group, or a linear, branched, or cyclic alkylene group having 1 to 12 carbon atoms, and some of methylene groups included in the alkylene group are optionally substituted with an ether group or an ester group, Rf¹ to Rf⁴ are each independently a hydrogen atom, a fluorine atom, or a trifluoromethyl group, and at least one of Rf¹ to Rf⁴ is a fluorine atom or a trifluoromethyl group, Rf¹ and Rf² may be combined to form a carbonyl group, R¹ to R⁵ are each independently a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, and some or all of hydrogen atoms of these groups may be substituted with a hydroxy group, a carboxyl group, a halogen atom, an oxo group, a cyano group, an amide group, a nitro group, a sultone group, a sulfone group, or a sulfonium salt-containing group, and some of methylene groups included in these groups are optionally substituted with an ether group, an ester group, a carbonyl group, a carbonate group, or a sulfonic acid ester group, and R¹ and R² may be bonded to each other to form a ring together with the sulfur atom to which R¹ and R² are bonded.

A resist material containing a base resin containing a polymer containing a repeating unit represented by formula (a) below.

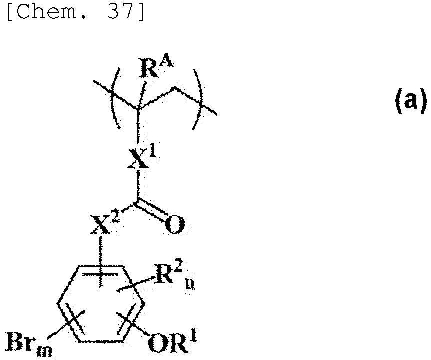

In the formula (a), R^{A} is a hydrogen atom or a methyl group, R¹ is a hydrogen atom or an acid-unstable group, R² is a linear, branched, or cyclic alkyl group having 1 to 6 carbon atoms or a halogen atom other than bromine, X¹ is a single bond, a phenylene group, or a linear, branched, or cyclic alkylene group which has 1 to 12 carbon atoms and may include an ester group or a lactone ring, X² is -O-, - O-CH₂-, or -NH-, m is an integer from 1 to 4, and u is an integer from 0 to 3, provided that m + u is an integer from 1 to 4.

A resist composition which generates an acid by light exposure and the solubility of which in a developer is changed by the action of the acid, the resist composition containing
a base material component (A) whose solubility in the developer is changed by the action of the acid and a fluorine additive component (F) exhibiting degradability to an alkaline developer, wherein
the fluorine additive component (F) contains a fluororesin component (F1) having a constituent unit (f1) containing a base dissociable group and a constituent unit (f2) containing a group represented by the following general formula (f2-r-1). 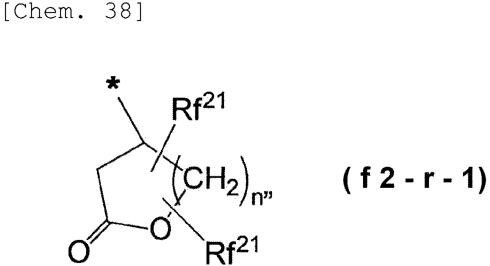
In the formula (f2-r-1), Rf²¹'s each independently are a hydrogen atom, an alkyl group, an alkoxy group, a hydroxy group, a hydroxyalkyl group, or a cyano group, n" is an integer from 0 to 2, and * is a bonding site.

The constituent unit (f1) includes a constituent unit represented by the following general formula (f1-1) or a constituent unit represented by the following general formula (f1-2). 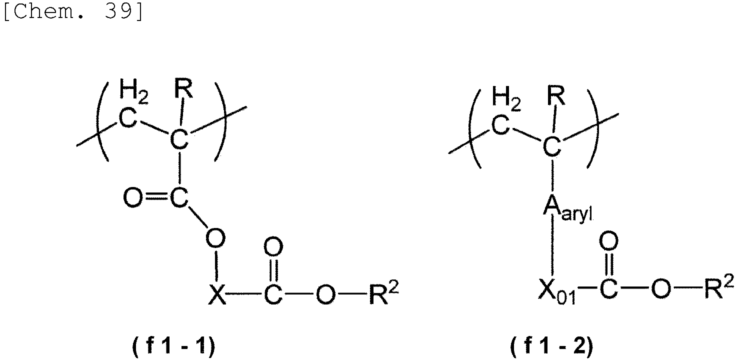 In the formulas (f1-1) and (f1-2), R's are each independently a hydrogen atom, an alkyl group having 1 to 5 carbon atoms, or a haloalkyl group having 1 to 5 carbon atoms, X is a divalent linking group not having an acid-dissociable site, A_{aryl} is a divalent aromatic ring group which may have a substituent, X₀₁ is a single bond or a divalent linking group, and R²'s each independently are an organic group having a fluorine atom.

The resist composition may be a metal-containing resist.

The metal-containing resist is also called a metal oxide resist (metal oxide resist (MOR)), and typical examples thereof include a tin oxide-based resist.

The material of the metal oxide resist is, for example, a coating composition containing a metal oxo-hydroxo network having an organic ligand through a metal carbon bond and/or a metal carboxylate bond described in JP 2019-113855 A.

In an example of the metal-containing resist, a peroxo ligand is used as a radiation-sensitive stabilizing ligand. Details of the peroxo based metal oxo-hydroxo compounds are described, for example, in patent literatures described in paragraph [0011] of JP 2019-532489 A. Examples of the patent literatures include US 9,176,377 B2, US 2013/0224652 A1, US 9,310,684 B2, US 2016/0116839 A1, and US 15/291738 A.

A coating containing a metal oxo-hydroxo network having organic ligands via metal carbon bonds and/or metal carboxylate bonds.

An inorganic oxo/hydroxo-based composition.

A coating solution containing: an organic solvent; a first organometallic composition represented by the formula R_{z}SnO_{(2-(z/2)-(x/2))}(OH)ₓ (where 0 < z ≤ 2 and 0 < (z + x) ≤ 4), the formula R'ₙSnX₄₋ₙ (here, n = 1 or 2), or a mixture thereof, in which R and R' independently represent a hydrocarbyl group having 1 to 31 carbon atoms and X represents a ligand having a hydrolysable bond to Sn or a combination of such ligands; and a hydrolysable metal compound represented by the formula MX'ᵥ (where M represents a metal selected from groups 2 to 16 in the periodic table, v is a number from 2 to 6, and X' represents a ligand having a hydrolysable M-X bond or a combination of such ligands).

A coating solution containing an organic solvent and a first organometallic compound represented by the formula RSnO_{(3/2-x/2)}(OH)ₓ (where 0 < x < 3), in which the solution contains from about 0.0025 M to about 1.5 M of tin, R is an alkyl group or a cycloalkyl group having 3 to 31 carbon atoms, and the alkyl group or cycloalkyl group is bonded to tin at a secondary or tertiary carbon atom.

An aqueous solution of a precursor for forming an inorganic pattern containing a mixture of water, a metal suboxide cation, a polyatomic inorganic anion, and a radiation-sensitive ligand containing a peroxide group.

Other examples of the metal-containing resist include compositions described in JP 2011-253185 A, WO 2015/026482 A, WO 2016/065120 A, WO 2017/066319 A, WO 2017/156388 A, WO 2018/031896 A, JP 2020-122959 A, JP 2020-122960 A, WO 2019/099981 A, WO 2019/199467 A, WO 2019/195522 A, WO 2019/195522 A, WO 2020/210660 A, WO 2021/011367 A, and WO 2021/016229 A.

These contents are incorporated herein to the same extent as if fully set forth.

The method for forming the metal-containing resist film from the metal-containing resist is not particularly limited, and examples thereof include a method in which a coating-type resist material (metal-containing resist film-forming composition) as the metal-containing resist is applied and fired.

The metal-containing resist film may be formed by vapor deposition. The method for forming the metal-containing resist film by vapor deposition is, for example, a method described in JP 2017-116923 A. The contents of JP 2017-116923 A are incorporated herein to the same extent as all the contents are specified. In JP 2017-116923 A, the metal-containing resist film in the present invention is referred to as a metal oxide-containing film.

Irradiation with light or an electron beam is performed, for example, through a mask (reticle) for formation of a predetermined pattern. For example, an i-line, a KrF excimer laser, an ArF excimer laser, an extreme ultraviolet ray (EUV), or an electron beam (EB) is used. The resist underlayer film-forming composition of the present invention is preferably applied for electron beam (EB) or extreme ultraviolet (EUV: 13.5 nm) irradiation, and more preferably applied for extreme ultraviolet (EUV) exposure.

The irradiation energy of the electron beam and the exposure amount of light are not particularly limited.

Post exposure bake (PEB) may be performed after irradiation with light or an electron beam and before development.

The baking temperature is not particularly limited, and is preferably 60°C to 150°C, more preferably 70°C to 120°C, and particularly preferably 75°C to 110°C.

The baking time is not particularly limited, and is preferably 1 second to 10 minutes, more preferably 10 seconds to 5 minutes, and particularly preferably 30 seconds to 3 minutes.

For the development, for example, an alkaline developer or an organic solvent is used.

The developing temperature is, for example, 5°C to 50°C.

The developing time is, for example, 10 seconds to 300 seconds.

As the alkaline developer, for example, an aqueous solution of an alkali such as an inorganic alkali (for example, sodium hydroxide, potassium hydroxide, sodium carbonate, sodium silicate, sodium metasilicate, or ammonia water), a primary amine (for example, ethylamine or n-propylamine), a secondary amine (for example, diethylamine or di-n-butylamine), a tertiary amine (for example, triethylamine or methyldiethylamine), an alcoholamine (for example, dimethylethanolamine or triethanolamine), a quaternary ammonium salt (for example, tetramethylammonium hydroxide, tetraethylammonium hydroxide, or choline), or a cyclic amine (for example, pyrrole or piperidine) can be used. Further, an alcohol such as isopropyl alcohol, or a surfactant such as a nonionic surfactant can be added in an appropriate amount to the aqueous solution of an alkali and used. Among these developers, an aqueous solution of a quaternary ammonium salt is preferable, and an aqueous solution of tetramethylammonium hydroxide and an aqueous solution of choline are more preferable. Further, a surfactant or the like can also be added to these developers. It is also possible to use a method in which development is performed with an organic solvent such as butyl acetate in place of the alkaline developer and a portion where the alkali dissolution rate of the photoresist is not improved is developed.

An organic solvent can be used as a developer of the metal-containing resist, and development is performed with the developer (solvent) after irradiation with light or an electron beam. As a result, for example, when a metal-containing negative resist film is used, the metal-containing resist film in an unexposed portion is removed, and a pattern of the metal-containing resist film is formed.

Examples of the developer (organic solvent) include methyl acetate, butyl acetate, ethyl acetate, isopropyl acetate, amyl acetate, isoamyl acetate, ethyl methoxyacetate, ethyl ethoxyacetate, propylene glycol monomethyl ether acetate, ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monopropyl ether acetate, diethylene glycol monoethyl ether acetate, diethylene glycol monophenyl ether acetate, diethylene glycol monobutyl ether acetate, diethylene glycol monoethyl ether acetate, 2-methoxybutyl acetate, 3-methoxybutyl acetate, 4-methoxybutyl acetate, 3-methyl-3-methoxybutyl acetate, 3-ethyl-3-methoxybutyl acetate, propylene glycol monomethyl ether acetate, propylene glycol monoethyl ether acetate, propylene glycol monopropyl ether acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, 4-methyl-4-methoxypentyl acetate, propylene glycol diacetate, methyl formate, ethyl formate, butyl formate, propyl formate, ethyl lactate, butyl lactate, propyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, methyl 2-hydroxypropionate, ethyl 2-hydroxypropionate, methyl-3-methoxypropionate, ethyl-3-methoxypropionate, ethyl-3-ethoxypropionate, and propyl-3-methoxypropionate. Further, a surfactant or the like can also be added to these developers.

Subsequently, the resist underlayer film is etched using the formed resist pattern as a mask. The etching may be dry etching or wet etching, but is preferably dry etching.

When the inorganic film is formed on the surface of a semiconductor substrate used, the surface of the inorganic film is exposed, and when the inorganic film is not formed on the surface of a semiconductor substrate used, the surface of the semiconductor substrate is exposed. Then, a semiconductor element can be produced through a step of processing the semiconductor substrate with a known method (dry etching method or the like).

### Examples

Next, the contents of the present invention will be specifically described with reference to Examples, but the present invention is not limited thereto.

The weight average molecular weight of each of the polymers shown in the following Synthesis Examples 1 to 3 and Comparative Synthesis Example 1 is a measurement result by gel permeation chromatography (hereinafter abbreviated as GPC). In the measurement, a GPC apparatus manufactured by Tosoh Corporation was used, and measurement conditions and the like are as follows:
· GPC column: TSKgel Super-Multipore HZ-N (two columns)
· Column temperature: 40°C
· Solvent: tetrahydrofuran (THF)
· Flow rate: 0.35 ml/min
· Standard sample: polystyrene (manufactured by Tosoh Corporation)

### <Synthesis Example 1>

To 35.03 g of propylene glycol monomethyl ether acetate, 7.50 g of 4-vinylphenyl acetate (manufactured by Tokyo Chemical Industry Co., Ltd.), 6.91 g of 4-nitrostyrene (manufactured by Tokyo Chemical Industry Co., Ltd.) (molar ratio: 50/50 (mol%)), and 0.61 g of azobisisobutyronitrile (manufactured by Tokyo Chemical Industry Co., Ltd.) were added and dissolved to prepare a monomer solution. 25.02 g of propylene glycol monomethyl ether acetate was placed in an empty reaction vessel, and the reaction vessel was purged with nitrogen, and then heated to 80°C while stirring. Next, the monomer solution was added dropwise to the reaction vessel over 1 hour, and the polymerization reaction was performed for a total of 6 hours with the start of dropwise addition of the monomer solution as the initiation time of the polymerization reaction to obtain a polymerization solution. After completion of the polymerization reaction, the polymerization solution was cooled to room temperature. The cooled polymerization solution was put into isopropyl alcohol, the precipitated yellow powder was separated by filtration, and 6.80 g of the resulting powder was dissolved in 20.40 g of propylene glycol monomethyl ether acetate. Next, 42.5 g of methanol, 4.25 g of triethylamine and 0.85 g of ultrapure water were added, and a hydrolysis reaction was performed at 70°C for 6 hours while stirring. After completion of the hydrolysis reaction, the remaining solvent was distilled off, and the residue was dissolved in propylene glycol monomethyl ether to obtain a polymer solution. As a result of GPC analysis, the polymer in the obtained solution had a weight average molecular weight of 8500 and a dispersity of 2.1 in terms of standard polystyrene. The polymer obtained in this Synthesis Example has a structural unit represented by formula (1) below.

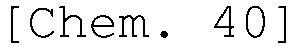

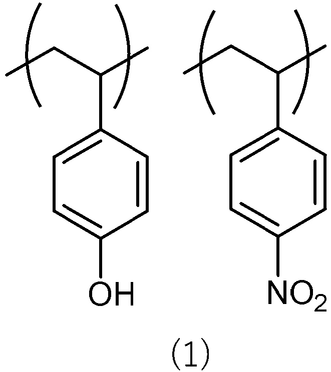

### <Synthesis Example 2>

To 29.42 g of propylene glycol monomethyl ether acetate, 7.50 g of 4-vinylphenyl acetate (manufactured by Tokyo Chemical Industry Co., Ltd.), 4.60 g of 4-nitrostyrene (manufactured by Tokyo Chemical Industry Co., Ltd.) (molar ratio: 60/40 (mol%)), and 0.51 g of azobisisobutyronitrile (manufactured by Tokyo Chemical Industry Co., Ltd.) were added and dissolved to prepare a monomer solution. 21.02 g of propylene glycol monomethyl ether acetate was placed in an empty reaction vessel, and the reaction vessel was purged with nitrogen, and then heated to 80°C while stirring. Next, the monomer solution was added dropwise to the reaction vessel over 1 hour, and the polymerization reaction was performed for a total of 6 hours with the start of dropwise addition of the monomer solution as the initiation time of the polymerization reaction to obtain a polymerization solution. After completion of the polymerization reaction, the polymerization solution was cooled to room temperature. The cooled polymerization solution was put into isopropyl alcohol, the precipitated yellow powder was separated by filtration, and 6.80 g of the resulting powder was dissolved in 20.40 g of propylene glycol monomethyl ether acetate. Next, 51.0 g of methanol, 5.10 g of triethylamine and 1.02 g of ultrapure water were added, and a hydrolysis reaction was performed at 70°C for 6 hours while stirring. After completion of the hydrolysis reaction, the remaining solvent was distilled off, and the residue was dissolved in propylene glycol monomethyl ether to obtain a polymer solution. As a result of GPC analysis, the polymer in the obtained solution had a weight average molecular weight of 14000 and a dispersity of 4.5 in terms of standard polystyrene. The polymer obtained in this Synthesis Example has a structural unit represented by formula (1) above.

### <Synthesis Example 3>

To 27.27 g of propylene glycol monomethyl ether acetate, 7.50 g of 4-vinylphenyl acetate (manufactured by Tokyo Chemical Industry Co., Ltd.), 3.71 g of 4-nitrostyrene (manufactured by Tokyo Chemical Industry Co., Ltd.) (molar ratio: 65/35 (mol%)), and 0.47 g of azobisisobutyronitrile (manufactured by Tokyo Chemical Industry Co., Ltd.) were added and dissolved to prepare a monomer solution. 19.48 g of propylene glycol monomethyl ether acetate was placed in an empty reaction vessel, and the reaction vessel was purged with nitrogen, and then heated to 80°C while stirring. Next, the monomer solution was added dropwise to the reaction vessel over 1 hour, and the polymerization reaction was performed for a total of 6 hours with the start of dropwise addition of the monomer solution as the initiation time of the polymerization reaction to obtain a polymerization solution. After completion of the polymerization reaction, the polymerization solution was cooled to room temperature. The cooled polymerization solution was put into isopropyl alcohol, the precipitated yellow powder was separated by filtration, and 6.80 g of the resulting powder was dissolved in 20.40 g of propylene glycol monomethyl ether acetate. Next, 55.25 g of methanol, 5.53 g of triethylamine and 1.11 g of ultrapure water were added, and a hydrolysis reaction was performed at 70°C for 6 hours while stirring. After completion of the hydrolysis reaction, the remaining solvent was distilled off, and the residue was dissolved in propylene glycol monomethyl ether to obtain a polymer solution. As a result of GPC analysis, the polymer in the obtained solution had a weight average molecular weight of 9700 and a dispersity of 4.0 in terms of standard polystyrene. The polymer obtained in this Synthesis Example has a structural unit represented by formula (1) above.

### <Comparative Synthesis Example 1>

100.00 g of monoallyl diglycidyl isocyanurate (manufactured by Shikoku Chemicals Corporation), 66.4 g of 5,5-diethylbarbituric acid, and 4.1 g of benzyltriethylammonium chloride were added to and dissolved in 682.00 g of propylene glycol monomethyl ether in a reaction vessel. The reaction vessel was purged with nitrogen, and then a reaction was allowed to proceed at 130°C for 24 hours to obtain a polymer solution. As a result of GPC analysis, the polymer in the obtained solution had a weight average molecular weight of 6,800 and a dispersity of 4.8 in terms of standard polystyrene. The polymer obtained in this Synthesis Example has a structural unit represented by formula below.

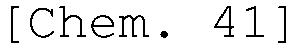

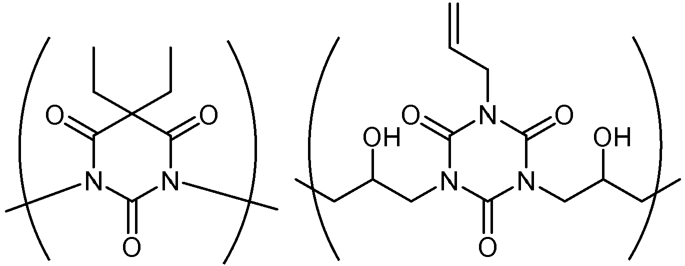

### <Preparation of resist underlayer film-forming composition>

### (Examples 1 to 5 and Comparative Examples 1 to 2)

The polymer obtained in each of Synthesis Examples 1 to 3 and Comparative Synthesis Example 1, and the following comparative polymer, a crosslinking agent, a curing catalyst, and a solvent were mixed in fractions shown in Table 1 or Table 2, and the mixture was filtered with a 0.1 µm fluororesin filter to prepare a resist underlayer film-forming composition. The following polymer was used as the comparative polymer. Abbreviations in Tables 1 and 2 are also shown.

· Comparative polymer: phenolic resin (Product name: VP-8000, manufactured by Nippon Soda Co.,Ltd., polymer not containing a nitro group)

Other abbreviations in Tables 1 and 2 are as follows.
· PL-LI: tetramethoxymethylglycoluril
· PGME-PL: imidazo[4,5-d]imidazole-2,5(1H,3H)-dione,tetrahydro-1,3,4,6-tetrakis[(2-methoxy-1-methylethoxy)methyl]-
· TMOM-BP: 3,3',5,5'-tetrakis(methoxymethyl)-[1,1'-biphenyl]-4,4'-diol
· HMOM-TPPA: 4,4'-[1-[4-[1-[4-hydroxy-3,5-bis(methoxymethyl)phenyl]-1-methylethyl]phenyl]ethylidene]-bis[2,6-bis(methoxymethyl)phenol]
· Py-PSA: pyridinium p-hydroxybenzenesulfonic acid
· R-30N: surfactant (manufactured by DIC Corporation)
· PGMEA: propylene glycol monomethyl ether acetate
· PGME: propylene glycol monomethyl ether

In Tables 1 and 2, each addition amount was expressed in parts by mass, and the solvent was expressed in composition ratio.

**[Table 1]**

| | | Polymer | Crosslinking agent | Curing catalyst | Solvent composition | |
|---|---|---|---|---|---|---|
| Example 1 | Type | Synthesis Example 1 | PGME-PL | Py-PSA | PGME | PGMEA |
| | (parts by mass) | 0.123 | 0.024 | 0.003 | 70 | 30 |
| Example 2 | Type | Synthesis Example 2 | PGME-PL | Py-PSA | PGME | PGMEA |
| | (parts by mass) | 0.123 | 0.024 | 0.003 | 70 | 30 |
| Example 3 | Type | Synthesis Example 3 | PGME-PL | Py-PSA | PGME | PGMEA |
| | (parts by mass) | 0.123 | 0.024 | 0.003 | 70 | 30 |
| Example 4 | Type | Synthesis Example 1 | TMOM-BP | Py-PSA | PGME | PGMEA |
| | (parts by mass) | 0.109 | 0.038 | 0.003 | 70 | 30 |
| Example 5 | Type | Synthesis Example 1 | HMOM-TPPA | Py-PSA | PGME | PGMEA |
| | (parts by mass) | 0.109 | 0.038 | 0.003 | 70 | 30 |

**[Table 2]**

| | | Polymer | Crosslinking agent | Curing catalyst | Surfactant | Solvent composition | |
|---|---|---|---|---|---|---|---|
| Comparative Example 1 | Type | Comparative Synthesis Example 1 | PL-LI | Py-PSA | R-30N | PGME | PGMEA |
| | (parts by mass) | 0.149 | 0.037 | 0.003 | 0.001 | 70 | 30 |
| Comparative Example 2 | Type | VP-8000 | PGME-PL | Py-PSA | - | PGME | PGMEA |
| | (parts by mass) | 0.139 | 0.014 | 0.003 | - | 70 | 30 |

### <Elution test into photoresist solvent>

Each of the resist underlayer film-forming compositions of Example 1 to Example 5 and Comparative Example 1 to Comparative Example 2 was applied onto a silicon wafer using a spinner. The silicon wafer was baked at 205°C for 60 seconds on a hot plate to obtain a film having a film thickness of 5 nm. These resist underlayer films were immersed in a mixed solution of propylene glycol monomethyl ether/propylene glycol monomethyl ether acetate = 70/30 (mass ratio), which is a solvent used for the photoresist, and a case where the film thickness change was 5 Å or less was evaluated as "good", and a case where the film thickness change was more than 5 Å was evaluated as "poor", and the results are shown in Table 3.

**[Table 3]**

| | Elution test |
|---|---|
| Example 1 | Good |
| Example 2 | Good |
| Example 3 | Good |
| Example 4 | Good |
| Example 5 | Good |
| Comparative Example 1 | Good |
| Comparative Example 2 | Good |

### <Resist pattern formation by electron beam lithography system>

Each of the resist underlayer film-forming compositions of Example 1 and Comparative Example 1 to 2 was applied onto a silicon wafer using a spinner. The silicon wafer was baked on a hot plate at 205°C for 60 seconds to obtain a resist underlayer film having a film thickness of 5 nm. A positive resist solution for EUV was spin-coated on the resist underlayer film, followed by heating to 110°C for 60 seconds to form an EUV resist film. The resist film was exposed under predetermined conditions using an electron beam lithography apparatus (ELS-G130). After the exposure, the film was baked (PEB) at 90°C for 60 seconds, cooled on a cooling plate to room temperature, and developed with an alkaline developer (2.38% TMAH) to form a resist pattern with 22 nm line pattern/ 44 nm pitch. A scanning electron microscope (CG4100 manufactured by Hitachi High-Technologies Corporation) was used to measure the dimensions of the resist pattern. In the formation of the resist pattern, a case where a line-and-space (LS) pattern having a CD size of 22 nm was formed was indicated as "good", and a case where the line-and-space pattern was collapsed or peeled was indicated as "poor" in Table 4. In addition, the charge amount at which the 22 nm line-and-space pattern was formed was defined as the optimum irradiation energy, and irradiation energies (µC/cm²) for which that in Comparative Example 1 was regarded as 1.00 are shown in Table 4. In addition, the resist pattern dimension (pattern collapse limit dimension) at the maximum exposure amount (limit exposure amount) at which the resist pattern does not collapse is also shown in Table 4. In Table 4, "-" indicates that the evaluation could not be performed.

**[Table 4]**

| | Whether or not to form LS pattern | Irradiation energy (µC/cm²) | Pattern collapse limit dimension (nm) |
|---|---|---|---|
| Example 1 | Good | 0.94 | 16.93 |
| Comparative Example 1 | Good | 1.00 | 19.76 |
| Comparative Example 2 | Poor | - | - |

From Table 4, it was confirmed that when the resist underlayer film was formed using the resist underlayer film-forming composition of Example 1, the optimum irradiation energy was reduced and the pattern collapse limit dimension was increased as compared with the case where the resist underlayer film was formed using the resist underlayer film-forming composition of Comparative Example 1.

## Claims

1. A resist underlayer film-forming composition comprising:
a polymer (A) containing a phenolic hydroxy group and a nitro group; and
a solvent (B).

2. The resist underlayer film-forming composition according to claim 1, wherein the polymer (A) is a vinyl polymer.

3. The resist underlayer film-forming composition according to claim 1, wherein the polymer (A) contains a structural unit (A1) represented by formula (A1) below and a structural unit (A2) represented by formula (A2) below: 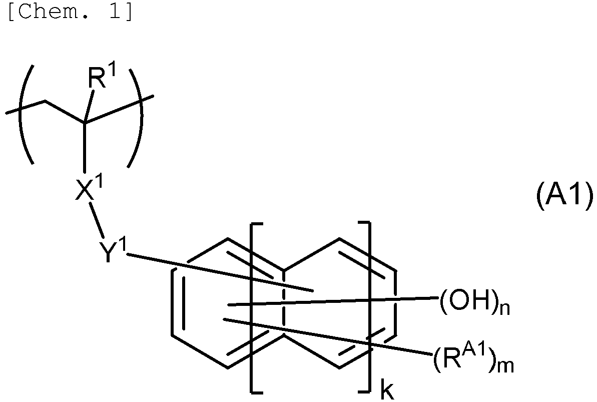 in the formula (A1), R¹ represents a hydrogen atom or a methyl group, X¹ represents a single bond, an ester bond or an amide bond, Y¹ represents a single bond or an alkylene group having 1 to 4 carbon atoms, R^{A1} represents a halogen atom, a carboxy group, a cyano group, a methylenedioxy group, an acetoxy group, a methylthio group, an amino group, an alkyl group having 1 to 9 carbon atoms or an alkoxy group having 1 to 9 carbon atoms, n represents an integer from 1 to 7, m represents an integer from 0 to 6, k represents an integer from 0 to 2, and when m is 2 or more, m R^{A1}'s may be the same or different; 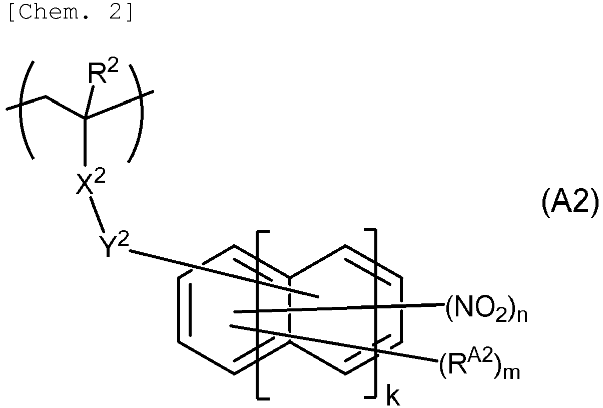 in the formula (A2), R² represents a hydrogen atom or a methyl group, X² represents a single bond, an ester bond or an amide bond, Y² represents a single bond or an alkylene group having 1 to 4 carbon atoms, R^{A2} represents a halogen atom, a carboxy group, a cyano group, a methylenedioxy group, an acetoxy group, a methylthio group, an amino group, an alkyl group having 1 to 9 carbon atoms or an alkoxy group having 1 to 9 carbon atoms, n represents an integer from 1 to 7, m represents an integer from 0 to 6, k represents an integer from 0 to 2, and when m is 2 or more, m R^{A2}'s may be the same or different.

4. The resist underlayer film-forming composition according to claim 1, wherein the solvent (B) contains at least one type selected from a group consisting of an alkylene glycol monoalkyl ether and a monocarboxylic acid ester of an alkylene glycol monoalkyl ether.

5. The resist underlayer film-forming composition according to claim 1, further comprising a crosslinking agent (C).

6. The resist underlayer film-forming composition according to claim 5, wherein the crosslinking agent (C) is at least one selected from the group consisting of aminoplast crosslinking agents and phenoplast crosslinking agents.

7. The resist underlayer film-forming composition according to claim 1, further comprising a curing catalyst (D).

8. The resist underlayer film-forming composition according to claim 1, which is used in EUV lithography.

9. The resist underlayer film-forming composition according to claim 1, wherein the composition is used for forming an underlayer film of a metal-containing resist.

10. A resist underlayer film, which is a cured product of the resist underlayer film-forming composition according to any one of claims 1 to 9.

11. A laminate, comprising:
a semiconductor substrate; and
the resist underlayer film according to claim 10.

12. A method for producing a semiconductor element, comprising:
a step of forming a resist underlayer film on a semiconductor substrate using the resist underlayer film-forming composition according to any one of claims 1 to 9; and
a step of forming a resist film on the resist underlayer film.

13. A pattern forming method comprising:
a step of forming a resist underlayer film on a semiconductor substrate using the resist underlayer film-forming composition according to any one of claims 1 to 9;
a step of forming a resist film on the resist underlayer film;
a step of irradiating the resist film with light or an electron beam, and then developing the resist film to obtain a resist pattern; and
a step of etching the resist underlayer film using the resist pattern as a mask.
